# EUROPÄISCHE PATENTANMELDUNG

(11) **EP 1 001 527 A2**
(43) Veröffentlichungstag der Anmeldung: **17.05.2000**
(21) Anmeldenummer: 99203605.3
(22) Anmeldetag: 02.11.1999
(51) Int. Cl.: H03G 1/00

(54) **Schaltungsanordnung zum Erzeugen eines Ausgangssignals**

(30) Priorität: 11.11.1998 DE 19851998
(71) Anmelder: Philips Corporate Intellectual Property GmbH, 52064 Aachen (DE); Koninklijke Philips Electronics N.V., 5621 BA Eindhoven (NL)
(72) Erfinder: Schillhof, Udo, c/o Philips Corp. Int. Prop. Gmbh, 52064 Aachen (DE); Bradinal, Werner c/o Philips Corp. Int. Prop. Gmbh, 52064 Aachen (DE); Nieke, Norbert, c/o Philips Corp. Int. Prop. Gmbh, 52064 Aachen (DE)
(74) Vertreter: Peters, Carl Heinrich

(57) **Zusammenfassung**

Beschrieben wird eine Schaltungsanordnung zum Erzeugen eines Ausgangssignals an einem Ausgang durch Verknüpfung wenigstens eines ersten und eines zweiten Eingangssignals, mit je wenigstens einem steuerbaren Schalter zum Zuführen je eines der Eingangssignale zum Ausgang, wobei zum Umsteuern des Ausgangs von einem der Eingangssignale zum anderen ein erster der steuerbaren Schalter allmählich vom gesperrten hin zum leitenden Zustand und ein zweiter der steuerbaren Schalter komplementär dazu vom leitenden hin zum gesperrten Zustand umgesteuert wird.

Um eine solche Schaltungsanordnung in der Weise auszubilden, daß Verzerrungen, die durch Toleranzen und Ungenauigkeiten in der Anpassung der Kennlinien der Bauelemente für das Umsteuern hervorgerufen werden, mit geringem Schaltungsaufwand vermieden werden können, wird erfindungsgemäß vorgeschlagen, daß die steuerbaren Schalter mit komplementär zueinander allmählich verändertem Tastverhältnis zwischen ihrem vollständig leitenden und ihrem vollständig gesperrten Zustand einander entgegengesetzt hin- und hergeschaltet werden.

## Beschreibung

Die Erfindung bezieht sich auf eine Schaltungsanordnung zum Erzeugen eines Ausgangssignals an einem Ausgang durch Verknüpfung wenigstens eines ersten und eines zweiten Eingangssignals, mit je wenigstens einem steuerbaren Schalter zum Zuführen je eines der Eingangssignale zum Ausgang, wobei zum Umsteuern des Ausgangs von einem der Eingangssignale zum anderen ein erster der steuerbaren Schalter allmählich vom gesperrten hin zum leitenden Zustand und ein zweiter der steuerbaren Schalter komplementär dazu vom leitenden hin zum gesperrten Zustand umgesteuert wird.

Aus der DE 32 00 071 A1 ist eine Signalübertragungsvorrichtung mit einer in Schritten einstellbaren Übertragungskennlinie bekannt, die wenigstens eine Gruppe steuerbarer Schalter zum Hindurchleiten eines Signals an unterschiedlichen Eingängen zu einem Ausgang enthält. In dieser Signalübertragungsvorrichtung sind Steuermittel vorhanden, mit deren Hilfe jeweils einer dieser Schalter in den leitenden Zustand geschaltet wird, wobei diese Schalter mittels eines Steuersignals in den leitenden Zustand und aus diesem Zustand geschaltet werden können. Ein Steuersignalgenerator ist vorhanden zum Erzeugen eines ersten sich zeitlich gleichmäßig ändernden Steuersignals, mit dessen Hilfe ein bestimmter Schalter aus der vorstehend genannten Gruppe steuerbarer Schalter allmählich in den leitenden Zustand gesteuert wird, und zum Erzeugen eines zweiten zu dem ersten Steuersignal komplementären Steuersignals, mit dessen Hilfe zugleich ein anderer Schalter aus dieser Gruppe gleichmäßig aus dem leitenden Zustand gesteuert wird. Das beschriebene Umsteuern der Schalter bzw. die Änderung der Steuersignale kann dabei stufenweise vorgenommen werden.

Aus der DE 196 35 050 A1 ist eine Schaltungsanordnung mit wenigstens zwei Signalpfaden, die durch je eine steuerbare Stromquelle zu speisen und durch jeweils eine der steuerbaren Stromquellen auswählende Logiksignale wechselweise wirksam zu schalten sind, bekannt. Dabei sind beim Übergang von einem Signalpfad aufeinen anderen während eines Übergangsintervalls die steuerbaren Stromquellen der betreffenden zwei Signalpfade durch ein zeitlich stetig sich änderndes Steuersignal derart zu steuern, daß sich von diesen beiden steuerbaren Stromquellen abgebbare Ströme stetig und gegensinnig ändern. Eine Einrichtung, mit der ein allmählicher Übergang von einer Einsteilposition zur nächsten erreicht wird, wird gemäß DE 196 35 050 A1 durch eine Ansteuerschaltung geschaffen, die zu jedem der Signalpfade eine Steuerstufe umfaßt. Jede der Steuerstufen enthält einen analogen Multiplexerzweig, über den ein die dem betreffenden Signalpfad zugehörige steuerbare Stromquelle wirksam schaltender Strom aus einer von der Ansteuerschaltung umfaßten, den Multiplexerzweigen aller Steuerstufen gemeinsamen Referenzstromquelle leitbar ist. Ferner enthält jede der Steuerstufen eine bistabile Stufe zum stetigen Steuern des Stromes im Multiplexerzweig nach Maßgabe des Steuersignals und zum Speichern des zum Ende des Übergangsintervalls erreichten Betriebszustandes des Multiplexerzweiges außerhalb des Übergangsintervalls sowie eine Schaltstufe zum Aufschalten des Steuersignals während des Übergangsintervalls mittels der logiksignale über die bistabile Stufe aufden Multiplexerzweig desjenigen Signalpfades, der nach Ablauf des Übergangsintervalls nach Maßgabe der Logiksignale wirksam zu schalten ist.

Bei den bekannten Schaltungsanordnungen erfolgt somit die Überblendung zwischen den Signalen an den unterschiedlichen Ausgängen zur Bildung des Ausgangssignals durch eine 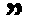 analoge" Umsteuerung. In diese analoge Umsteuerung fließt als wesentlicher Einflußfaktor die Steuerkennlinie der zur Umsteuerung verwendeten Bauelemente ein. Durch Ungenauigkeiten in diesen Kennlinien, insbesondere durch Toleranzabweichungen und ungenaue Abstimmungen der Kennlinien aufeinander verursacht, können Verzerrungen auftreten, die sich insbesondere bei großen Signaldifferenzen bei der Überblendung bemerkbar machen. Diese Verzerrungen können die Wiedergabequalität des Ausgangssignals merkbar beeinflussen. Wenn insbesondere eine solche Schaltungsanordnung zur Lautstärkesteuerung in Geräten zur Audiosignalwiedergabe eingesetzt wird, können die genannten Verzerrungen hörbar werden und somit den Höreindruck verschlechtern.

Die Erfindung hat die Aufgabe eine Schaltungsanordnung der gattungsgemäßen Art in der Weise auszubilden, daß Verzerrungen, die durch Toleranzen und Ungenauigkeiten in der Anpassung der Kennlinien der Bauelemente für das Umsteuern hervorgerufen werden, mit geringem Schaltungsaufwand vermieden werden können.

Erfindungsgemäß wird diese Aufgabe bei einer Schaltungsanordnung der gattungsgemäßen Art dadurch gelöst, daß die steuerbaren Schalter mit komplementär zueinander allmählich verändertem Tastverhältnis zwischen ihrem vollständig leitenden und ihrem vollständig gesperrten Zustand einander entgegengesetzt hin- und hergeschaltet werden.

Gemäß der Erfindung werden somit die steuerbaren Schalter, die als Bauelemente für das Umsteuern vorgesehen sind, wechselweise stets in ihren vollständig leitenden oder vollständig gesperrten Zustand geschaltet. Da somit der mittlere Kennlinienbereich dieser Bauelemente zwischen den beiden genannten Zuständen für die Gewinnung des Ausgangssignals aus den über die steuerbaren Schalter zugeführten Eingangssignalen keine Rolle spielt, können Nichtliniaritäten in diesem mittleren Kennlinienbereich oder eine ungenügende komplementäre Anpassung aneinander das Betriebsverhalten der erfindungsgemäßen Schaltungsanordnung nicht berühren. Damit kann auch unter Verwendung von Bauelementen mit ungenügender Liniarität im mittleren Kennlinienbereich bzw. ungenügender Abstimmung aufeinander ein einwandfreies Umsteuern ohne Signalfehler erreicht werden.

Aufgrund dieser vorteilhaften Eigenschaften beim Umsteuern des Ausgangs der Schaltungsanordung zwischen zwei Eingangssignalen kann die erfindungsgemäße Schaltungsanordnung auch zur statischen Einstellung einer Liniarkombination wenigstens zweier Eingangssignale eingesetzt werden und nicht nur zum dynamischen Umsteuern des Ausgangs von einem der Eingangssignale in einem ersten statischen Zustand auf ein zweites Eingangssignal in einem zweiten statischen Zustand. Dabei ist auch eine Liniarkombination aus mehr als zwei Eingangssignalen möglich, wobei dann eine entsprechende Anzahl steuerbarer Schalter komplementär zueinander zwischen jeweils ihrem vollständig leitenden und ihrem vollständig gesperrten Zustand einander entgegengesetzt in der Weise hin- und hergeschaltet werden, daß zu jedem Zeitpunkt stets nur einer der Schalter leitend und die übrigen gesperrt sind.

Bei einer statischen Einstellung einer Liniarkombination zweier oder mehrerer Eingangssignale bleibt das Tastverhältnis, mit dem die steuerbaren Schalter hin- und hergeschaltet werden, zeitlich konstant.

In einer vorteilhaften Ausgestaltung ist der Ausgang der erfindungsgemäßen Schaltungsanordnung mit einer Integrationsanordnung zum Integrieren bzw. Tiefpaßfiltern des Ausgangssignals verbunden. Durch diese Integrationsanordnung können bevorzugt aus dem Ausgangssignal diejenigen Signalkomponenten ausgefiltert werden, die darin durch das Hin- und Herschalten der steuerbaren Schalter auftreten. Diese Signalkomponenten können dann keinen Einfluß mehr aufeine weitere Verarbeitung des Ausgangssignals ausüben.

In einer anderen Fortbildung der erfindungsgemäßen Schaltungsanordnung wird das Umsteuern des Ausgangs von einem der Eingangssignale zum anderen innerhalb eines Umsteuerzeitintervalls vorgebbarer Dauer vorgenommen. Das Tastverhältnis der zugehörigen steuerbaren Schalter wird dann innerhalb dieses Umsteuerzeitintervalls komplementär zueinander allmählich von Null auf 100 % erhöht bzw. von 100 % auf Null verringert. Die Dauer des Umsteuerzeitintervalls kann bevorzugt einstellbar ausgeführt sein und vorteilhaft einen Wert von kleiner oder gleich 1 msec bis größer oder gleich 20 msec aufweisen.

Nach einer anderen Ausgestaltung umfaßt die erfindungsgemäße Schaltungsanordnung eine Steueranordnung zum Erzeugen zweier zueinander komplementärer Steuersignale zum einander komplementären Hin- und Herschalten der steuerbaren Schalter. Diese Steuersignale sind insbesondere durch in ihrer Pulsdichte bzw. Pulsfrequenz gesteuerte Impulssignale gebildet.

Es zeigt sich, daß die Steuerung der Pulsdichte bzw. Pulsfrequenz in den Steuersignalen gegenüber einer Ausbildung dieser Steuersignale als pulsweitenmodulierte Impulssignale konstanter Frequenz und variablen Tastverhältnisses den Vorteil hat, daß bei vergleichbaren Eigenschaften der so gebildeten Steuersignale bzw. bei vergleichbarer Qualität des gebildeten Ausgangssignals für die Erzeugung eines pulsweitengesteuerten Steuersignals konstanter Pulsfrequenz ein Taktsignal mit wesentlich höherer Taktfrequenz erforderlich ist als für die Bildung eines in seiner Pulsdichte bzw. Pulsfrequenz gesteuerten Impulssignals. Auch ist der benötigte Schaltungsaufwand für die Erzeugung eines pulsweitengesteuerten Impulssignals wesentlich höher als derjenige für die Erzeugung eines pulsdichte- bzw. pulsfrequenzgesteuerten Impulssignals. Im Gegensatz dazu kann ein in seiner Pulsdichte bzw. Pulsfrequenz gesteuertes Impulssignal mit einem sehr viel geringeren Aufwand an Bauelementen und mit einer sehr viel geringeren Taktfrequenz erzeugt werden. Bei einem solchen Impulssignal ist die Impulsweite konstant, wohingegen die Wiederholungsfrequenz der Impulse einstellbar ausgeführt wird. Dann bestimmt allein die Anzahl der Impulse je Zeiteinheit im Impulssignal den zeitlichen Verlauf des Ausgangssignals der erfindungsgemäßen Schaltungsanordnung.

Bevorzugt ist die Steueranordnung zum schrittweisen Ändern der Pulsdichte bzw. Pulsfrequenz der Steuersignale ausgebildet. Diese schrittweise Änderung ist einerseits in einfacher Weise mit digitalen Schaltkreisen zu bewerkstelligen und kann andererseits in einer derart feinen Abstufung vorgenommen werden, daß sie im zu erzeugenden Ausgangssignal wie eine quasi kontinuierliche Änderung wirkt.

Weiterhin werden vorteilhaft sowohl für die Pulsdichte bzw. Pulsfrequenz der Steuersignale als auch für die Wiederholungsfrequenz der Schritte des schrittweisen Änderns der Pulsdichte bzw. Pulsfrequenz der Steuersignale ausschließlich Frequenzen außerhalb des hörbaren Frequenzbereichs verwendet. Bei einem Einsatz der erfindungsgemäßen Schaltungsanordnung zur Bearbeitung von Audiosignalen erleichtert diese Maßnahme wesentlich die Unterdrückung hörbarer Einflüsse auf das Audiosignal durch die erfindungsgemäße Behandlung der Signale. Insbesondere verringert sich der Aufwand für eine mit dem Ausgang zu verbindende Integrationsanordnung, wenn durch das Umsteuern in das Ausgangssignal einfließende Frequenzen jenseits, vorzugsweise weit jenseits des hörbaren Frequenzbereichs liegen. Andererseits ist es zweckmäßig, die höchste auftretende Frequenz, insbesondere die Wiederholungsfrequenz der Impulse im Impulssignal, unterhalb einer bestimmten Grenze zu wählen. Zusammenfassend ausgedrückt werden jedoch die steuerbaren Schalter bei der vorstehenden Ausgestaltung der Erfindung in zur Zeitdauer des Umsteuervorgangs kurzen Intervallen hin- und hergeschaltet.

An dieser Stelle sei bemerkt, daß aus der DE 27 40 567 A1 ein Dämpfungsglied für Tonfrequenzsignale, insbesondere für Mischpulte, bekannt ist, bei dem die Tonfrequenzsignale über einen Schalter geführt sind, dessen Steuereingang an einen Impulsgeber angeschlossen ist. Dieser Impulsgeber gibt Impulse mit einstellbarem Puls-Pausen-Verhältnis und mir einer Wiederholfrequenz ab, die mindestens gleich der doppelten oberen Grenzfrequenz des zu übertragenden Frequenzbereichs der Tonfrequenzsignale ist. Dem Schalter ist ein den zu übertragenden Frequenzbereich überdeckender Tiefpaß nachgeschaltet.

Bei diesem bekannten Dämpfungsglied erfolgt jedoch kein Umsteuern zwischen wenigstens zwei Eingangssignalen, vielmehr werden diskrete Dämpfungsstufen für ein Signal nur durch pulsweitenmodulierte Tastung bewerkstelligt. Eine solche Tastung ist auch für eine statische Einstellung einer vorgegebenen Dämpfung unumgänglich.

Nach einer weiteren Ausgestaltung der Erfindung umfaßt die Steueranordnung eine Akkumulationsschaltung, der Ausgangsdatensignale einer Zählerstufe zum Aufakkumulieren zugeführt werden und von der ein Übertragungssignal zum Steuern einer bistabilen D-Kippstufe abgeleitet wird, wobei Zählerstufe, Akkumulationsschaltung und bistabile D-Kippstufe aus einem gemeinsamen Taktsignal getaktet werden und den Ausgängen der bistabilen D-Kippstufe die komplementären Steuersignale entnehmbar sind. Auf diese Weise wird ein sehr einfacher Aufbau für die Steueranordnung erreicht. Durch das gemeinsame Taktsignal wird der Zählerstand der Zählerstufe während des Umsteuerns laufend erhöht, wodurch in der Akkumulationsschaltung laufend zunehmende Werte aufakkumuliert werden. Dadurch erhöht sich die Wiederholungsfrequenz des Übertragssignals in gleichem Maße, so daß die Pulsdichte der von der bistabilen D-Kippstufe abgegebenen Impulse laufend zunimmt. Die Anzahl der Perioden des gemeinsamen Taktsignals, in denen ein beispielsweise positiver Pegel (hoher logischer Pegel) auftritt, wird somit laufend vergrößert, und zwar ausgehend von Null bis im Endzustand, in dem in jeder Periode des gemeinsamen Taktsignals ein Übertragssignal auftritt, auf 100 %. Den Ausgängen der bistabilen D-Kippstufe können dann in einfacher Weise dieses Impulssignal und sein Inverses als komplementäre Steuersignale entnommen werden.

Bei dieser Ausgestaltung wird die Dauer des Umsteuerzeitintervalls durch die Frequenz des der Zählerstufe zugeführten Taktsignals, die Anzahl der binären Stellen der Zählerstufe sowie die Anzahl der binären Stellen der Akkumulationsschaltung bestimmt. Wird nun nach einer weiteren Fortbildung der Erfindung das Taktsignal der Zählerstufe über eine einstellbare Taktfrequenzteilerstufe zugeführt, kann damit in einfacher Weise die Dauer des Umsteuerzeitintervalls eingestellt werden.

Nach einer anderen Ausgestaltung umfaßt die erfindungsgemäße Schaltungsanordnung wenigstens drei steuerbare Schalter zum Zuführen je eines Eingangssignals, wobei das Umsteuern des Ausgangs von jedem der Eingangssignale zu einem beliebig wählbaren der anderen Eingangssignale durchführbar ist. In einer Abwandlung dieser Ausgestaltung sind die genannten wenigstens drei Eingangssignale gemäß ihren Signalpegeln in eine vorgegebene Reihenfolge eingeordnet und wird das Umsteuern des Ausgangs von je einem der Eingangssignale nur zu den in dieser Reihenfolge benachbarten Eingangssignalen vorgenommen. Eine derartige vorgegebene Reihenfolge kann auch in der erstgenannten Variation, bei der von jedem der Eingangssignale zu einem beliebig wählbaren der anderen Eingangssignale umgesteuert werden kann, ebenfalls vorhanden sein; beim Umsteuern nach dieser Variation sind dann beliebige Sprünge im Umsteuern zwischen den Eingangssignalen möglich.

Um ein Umsteuern der vorstehend beschriebenen Arten zu bewerkstelligen, ist nach einer weiteren Fortbildung der erfindungsgemäßen Schaltungsanordnung vorgesehen, daß die Steueranordnung eine Ablaufsteuerstufe umfaßt, der ausgehend von einem Anfingszustand der Schaltungsanordnung, in dem ein erstes ausgewähltes Eingangssignal dem Ausgang zugeführt wird, über eine Datenübertragungsstrecke ein Informationssignal über ein zweites ausgewähltes Eingangssignal zugeleitet wird, welches in einem Endzustand der Schaltungsanordnung nach dem Umsteuern des Ausgangs diesem zugeführt wird. Als eine derartige Datenübertragungsstreke kann bevorzugt ein sogenannter I²C-Bus zum Einsatz kommen, über den von einer übergeordneten Systemsteueranordnung das entsprechende Informationssignal zugeführt wird.

Die Ablaufsteuerstufe umfaßt bevorzugt ein erstes Zustandsspeicherelement zum Speichern eines Informationssignals für den Anfangszustand und ein zweites Zustandsspeicherelement zum Speichern des Informationssignals für den Endzustand. Durch diese Informationssignale werden die im Anfangs- bzw. Endzustand dem Ausgang zuzuführenden Eingangssignale ausgewählt und wird das Umsteuern zwischen diesen Eingangssignalen vorgenommen. Nach Ausführen des Umsteuerns wird das Informationssignal für den Endzustand vom ersten Zustandsspeicherelement in das zweite Zustandsspeicherelement übertragen, worauf das erste Zustandsspeicherelement zum Zuleiten eines neuen Informationssignals für einen neuen (weiteren) Endzustand bereit ist. Dieser neue (weitere) Endzustand kennzeichnet das jeweilige Ende des jeweiligen Umsteuervorgangs von dem jeweiligen ersten zum jeweiligen zweiten ausgewählten Eingangssignal. Bei der Erzeugung des Ausgangssignals können sich in unterschiedlich gewünschter Weise mehrere derartige Umsteuervorgänge aneinander anschließen. Sind die ausgewählten Eingangssignale Teil einer Menge von Eingangssignalen, die in eine vorgegebene Reihenfolge eingeordnet sind, können sie in dieser Reihenfolge benachbart oder nicht benachbart sein. Für das Umsteuern zwischen zwei benachbarten Eingangssignalen wird ein einziger Umsteuervorgang durchgeführt.

Ein Umsteuern zwischen zwei einander nicht benachbarten, ausgewählten Eingangssignalen kann dagegen aufzwei Arten durchgeführt werden. Zum einen ist ein unmittelbares Umsteuern ohne Umsteuern aufweitere, in der genannten Reihenfolge zwischenliegende Eingangssignale möglich. Andererseits kann das Umsteuern von einem Eingangssignal nur zu dem dazu in der vorgegebenen Reihenfolge benachbarten Eingangssignal vorgenommen werden, so daß ein Umsteuern von einem Eingangssignal zu einem dazu nicht benachbarten Eingangssignal nacheinander über jedes der in der vorgegebenen Reihenfolge dazwischen liegenden Eingangssignale erfolgt. In diesem Fall kann der Ablaufsteuerstufe über die Datenübertragungsstrecke zu jedem einzelnen Umsteuerschritt erneut ein Informationssignal für den jeweiligen Endzustand des jeweils auszuführenden Umsteuerns zugeleitet werden. Eine wesentliche Vereinfachung des Betriebsablaufs insbesondere für die Datenübertragungsstrecke und eine damit verbundene, übergeordnete Systemsteuerung wird jedoch dadurch erreicht, daß die Ablaufsteuerstufe eine Schrittsteuerung umfaßt, durch die das Umsteuern aus dem Anfangszustand in den Endzustand in einzelnen Umsteuervorgängen zwischen je zwei in der vorgegebenen Reihenfolge benachbarten Eingangssignalen durchgeführt wird. Der Ablaufsteuerstufe muß dann über die Datenübertragungsstrecke nur noch ein Informationssignal über den Endzustand zugeleitet werden, worauf die Schrittsteuerung die zum Erreichen dieses Endzustands notwendigen, einzelnen Umsteuervorgänge selbsttätig nacheinander ausführt.

Bei dieser Ausbildung der erfindungsgemäßen Schaltungsanordnung ist vorteilhaft bei jedem der einzelnen Umsteuervorgänge im ersten Zustandsspeicherelement das Informationssignal für das zu Beginn dieses einzelnen Umsteuervorgangs dem Ausgang zuzuführende Eingangssignal (im folgenden als 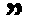 voraufgehendes Eingangssignal" bezeichnet) gespeichert. Im zweiten Zustandsspeicherelement ist das Informationssignal für das in der vorgegebenen Reihenfolge benachbarte Eingangssignal (im folgenden als 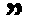 nachfolgendes Eingangssignal" bezeichnet) gespeichert. Bevorzugt wird bei jedem der einzelnen Umsteuervorgänge durch die Informationssignale das voraufgehende Eingangssignal bzw. das nachfolgende Eingangssignal ausgewählt und wird der einzelne Umsteuervorgang zwischen diesen Eingangssignalen vorgenommen. Nach Ausführen dieses einzelnen Umsteuervorgangs wird das Informationssignal für das nachfolgende Eingangssignal vom ersten Zustandsspeicherelement in das zweite Zustandsspeicherelement übertragen, worauf das erste Zustandsspeicherelement zum Zuleiten des Informationssignals für das nächste in der vorgegebenen Reihenfolge benachbarte Eingangssignal bereit ist, bis das Informationssignal für den Endzustand in das zweite Zustandsspeicherelement übertragen ist. Das gesamte, aus den einzelnen Umsteuervorgängen sich zusammensetzende Umsteuern ist damit beendet, und das erste Zusrandsspeicherelement ist dann für ein Informationssignal für ein neues gesamtes Umsteuern bzw. für den ersten Zwischenschritt, d.h. den ersten einzelnen Umsteuervorgang eines solchen neuen gesamten Umsteuerns, bereit.

In einer bevorzugten Ausbildung der erfindungsgemäßen Schaltungsanordnung sind die Eingangssignale durch Pegelabstufung aus einem gemeinsamen Eingangssignal abgeleitet. Bevorzugt wird als derartige Pegelabstufung eine Potential- bzw. Spannungsteilung, beispielsweise über einen ohmschen Spannungsteiler, vorgenommen.

Die erfindungsgemäße Schaltungsanordnung findet vorteilhaft Verwendung in Geräten zur Signalverarbeitung, insbesondere zur Audiosignalverarbeitung bzw. Audiosignalsteuerung. Sie ist einsetzbar für Lautstärkesteuerung, Klangeinstellung, eine weiche Quellenumschaltung und weiche Stummschaltungen beispielsweise in Rundfunk-und Fernsehgeräten. Darüber hinaus ist eine Anwendung grundsätzlich für alle analogen Eingangssignale möglich.

Ein Ausführungsbeispiel der erfindungsgemäßen Schaltungsanordnung ist in der Zeichnung dargestellt und wird im nachfolgenden näher beschrieben. Es zeigen:
- Fig. 1: das Prinzipschaltbild eines Ausführungsbeispiels der Erfindung,
- Fig. 2: eine tabellarische, schematische Darstellung zur Funktionsweise der Schaltungsanordnung nach Fig. 1,
- Fig. 3: ein Beispiel für eine erfindungsgemäße Steueranordnung,
- Fig. 4: ein Diagramm zur Darstellung der Augenblicksfrequenz der von der Steueranordnung nach Fig. 3 abgegebenen Steuersignale während des Vorgangs des Umsteuerns,
- Fig. 5: ein Ausführungsbeispiel für eine erfindungsgemäße Ablaufsteuerstufe und
- Fig. 6: eine Abwandlung der Ablaufsteuerstufe nach Fig. 5 mit einer Schrittsteuerung
In allen Figuren sind übereinstimmende Elemente mit identischen Bezugszeichen versehen.

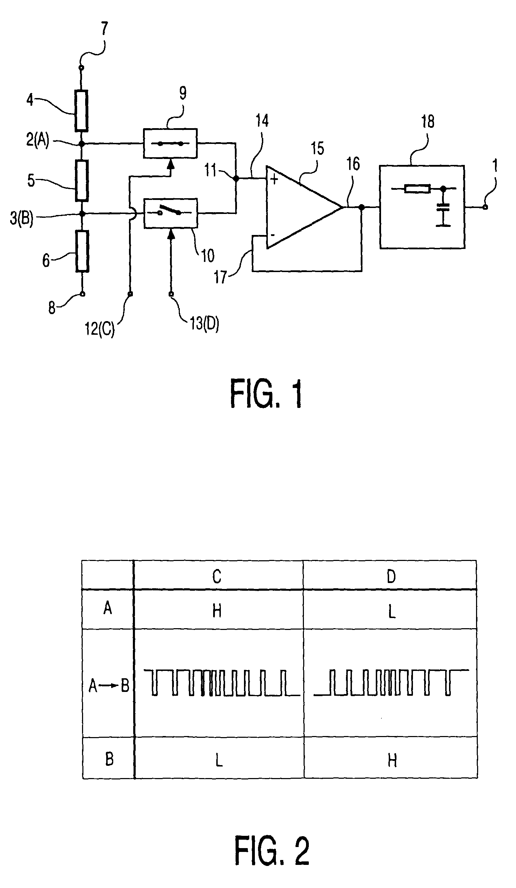

Fig. 1 zeigt in blockschematischer Darstellung eine Schaltungsanordnung zum Erzeugen eines Ausgangssignals an einem Ausgang 1 durch Verknüpfung von Eingangssignalen, wobei zur Vereinfachung der Darstellung lediglich ein erstes und ein zweites Eingangssignal angenommen sind. Das erste Eingangssignal wird über einen ersten Eingangsanschluß 2, das zweite Eingangssignal über einen zweiten Eingang 3 zugeleitet. Das erste Eingangssignal ist mit A, das zweite Eingangssignal mit B bezeichnet. Im Ausführungsbeispiel nach Fig. 1 werden der erste und der zweite Eingang 2, 3 durch Abgriffe eines ohmschen Spannungsteilers aus ohmschen Widerständen 4, 5, 6 gebildet. Diesem ohmschen Spannungsteiler 4, 5, 6 kann über seine Endanschlüsse 7, 8 eine Signalspannung bzw. ein Signalstrom zugeführt werden, beispielsweise in der Form, daß dem ersten Endanschluß 7 die genannte Signalspannung zugeleitet wird, während der zweite Endanschluß 8 an eine Referenzspannung gelegt wird. Die Eingangssignale A, B bilden dann Teilabstufungen der genannten Signalspannung. Durch die erfindungsgemäße Schaltungsanordnung kann zwischen diesen Teilabstufungen umgesteuert werden und so das Ausgangssignal am Ausgang 1 erzeugt werden. In einer Abwandlung dieses Ausführungsbeispiels können den Eingängen 2, 3 auch voneinander unabhängige Eingangssignale A, B zugeleitet werden.

Die Schaltungsanordnung nach Fig. 1 umfaßt weiterhin zu jedem der Eingänge 2, 3 einen steuerbaren Schalter 9 bzw. 10, die einerseits mit dem zugeordneten Eingang 2 bzw. 3 und andererseits mit einem gemeinsamen Verbindungspunkt 11 verbunden sind und in ihrem leitenden Zustand das zugehörige Eingangssignal A bzw. B vom betreffenden Eingang 2 bzw. 3 dem gemeinsamen Verbindungspunkt 11 zuführen. Durch komplementär zueinander erfolgendes, allmähliches Umsteuern der steuerbaren Schalter wird somit der gemeinsame Verbindungspunkt 11 von einem der Eingänge 2, 3 zum anderen umgesteuert und somit das Signal am Verbindungspunkt 11 von dem einen Eingangssignal zum anderen Eingangssignal (A bzw. B) überführt. Die steuerbaren Schalter 9, 10, die in Fig. 1 schematisch als mechanische Schalter dargestellt sind, werden bevorzugt als elektronische Schalter mit Steueranschlüssen 12 bzw. 13 ausgeführt. Bevorzugt sind die steuerbaren Schalter 9, 10 in ihrem leitenden Zustand, wenn ihren Steueranschlüssen 12 bzw. 13 ein Steuersignal mit einem hohen logischen Pegel H zugeführt wird, und sind in ihrem gesperrten Zustand, wenn ihren Steueranschlüssen 12 bzw. 13 ein Steuersignal mit einem niedrigen logischen Pegel L zugeführt wird. Im Betrieb wird dem Steueranschluß 12 des ersten steuerbaren Schalters 9 ein erstes Steuersignal C und dem Steueranschluß 13 des zweiten steuerbaren Schalters 10 ein zweites Steuersignal D zugeleitet.

Der gemeinsame Verbindungspunkt 11 der steuerbaren Schalter 9, 10 ist im Ausführungsbeispiel 1 mit einem nicht invertierenden Eingang 14 eines Operationsverstärkers 15 verbunden, dessen Ausgangsanschluß 16 mit seinem invertierenden Eingang 17 kurzgeschlossen ist und der somit eine niederohmige Quelle für das zu erzeugende Ausgangssignal darstellt.

Der Ausgangsanschluß 16 des Operationsverstärkers 15 ist über eine Integrationsanordnung 18 mit dem Ausgang 1 verbunden. Die Integrationsanordnung 18 ist blockschematisch als RC-Kombination dargestellt und kann im einfachsten Fall einen ohmschen Längswiderstand und eine Querkapazität vom Ausgang 1 gegen ein Bezugspotential, vorzugsweise Masse umfassen. Falls eine wirkungsvollere Integration bzw. Tiefpaßfilterung des Ausgangssignals erforderlich ist, können für die Integrationsanordnung 18 auch aufwendigere Filterschaltungen zum Einsatz gelangen.

Zur Erläuterung der Funktionsweise der Schaltungsanordnung nach Fig. 1 wird im folgenden auf die Tabelle gemäß Fig. 2 Bezug genommen. Diese zeigt schematisch die den Steueranschlüssen 12 bzw. 13 zuzuführenden Steuersignale C bzw. D in Abhängigkeit von den ausgewählten Eingangssignalen A bzw. B bzw. beim Umsteuern des Ausgangs 1 zwischen diesen Eingangssignalen A und B. Befindet sich das erste Steuersignal C zeitlich konstant auf hohem logischem Pegel H und das zweite Steuersignal D dazu komplementär, d.h. zeitlich konstant auf niedrigem logischem Pegel L, nehmen die steuerbaren Schalter 9, 10 die in Fig. 1 dargestellten Zustände an, d.h. der erste steuerbare Schalter 9 befindet sich im leitenden, der zweite steuerbare Schalter 10 im gesperrten Zustand. Dem Ausgang 1 wird somit das erste Eingangssignal A vom ersten Eingang 2 als Ausgangssigal zugeleitet, bzw. dieses Ausgangssignal wird aus dem ersten Eingangssignal A erzeugt. In einem zweiten, zeitlich konstanten Schaltzustand nimmt das erste Steuersignal C einen niedrigen logischen Pegel L und das zweite Steuersignal D einen hohen logischen Pegel H an. Der erste steuerbare Schalter 9 befindet sich dann im gesperrten Zustand, während sich der zweite steuerbare Schalter 10 im leitenden Zustand befindet. Das Ausgangssignal am Ausgang 1 wird dann aus dem zweiten Eingangssignal B erzeugt, wohingegen der Signalweg für das erste Eingangssignal A unterbrochen ist.

Zum Umsteuern des Ausgangs 1 beispielsweise vom ersten Eingangssignal A zum zweiten Eingangssignal B wird dem Steueranschluß 12 des ersten steuerbaren Schalters 9 als erstes Steuersignal ein Impulssignal zugeleitet, d.h. ein Steuersignal, welches zwischen dem hohem und dem niedrigen logischen Pegel hin- und herschaltet. Wie in der Tabelle gemäß Fig. 2 angedeutet ist, hat das Impulssignal, welches als erstes Steuersignal C dient, ausgehend vom hohen logischen Pegel H vereinzelte, kurze Impulse mit niedrigem logischem Pegel L. Das zweite Steuersignal D, welches dem Steueranschluß 13 des zweiten steuerbaren Schalters 10 zugeführt wird, ist dazu komplementär ausgebildet, weist also einen niedrigen logischen Pegel L auf, in dem zu den Zeiten, in denen im ersten Steuersignal C Impulse mit niedrigem logischem Pegel L auftreten, Impulse mit hohem logischem Pegel H vorhanden sind. Somit bildet das zweite Steuersignal D zu jedem Zeitpunkt das logische Inverse des ersten Steuersignals C. Die Dichte bzw. Frequenz der Impulse des ersten Steuersignals C mit niedrigem logischem Pegel L und der Impulse des zweiten Steuersignals D mit hohem logischem Pegel H wird nun, beginnend mit einem sehr niedrigen Wert, allmählich so weit gesteigert, bis schließlich die Impulse so schnell aufeinander folgenden, daß das erste Steuersignal C einen konstanten niedrigen logischen Pegel L und das zweite Steuersignal D einen konstanten hohen logischen Pegel H aufweist. Wenn dieser Zustand erreicht ist, ist der Ausgang 1 vom ersten Eingang 2 mit dem ersten Eingangssignal A auf den zweiten Eingang 3 mit dem zweiten Eingangssignal B umgesteuert. Das Zeitintervall, innerhalb dessen die Steuersignale C, D den beschriebenen impulsförmigen Verlauf aufweisen, wird als Umsteuerzeitintervall bezeichnet.

Die vorstehend beschriebene Ausbildung der Steuersignale C, D als in ihrer Pulsdichte bzw. Pulsfrequenz gesteuerte Impulssignale stellt nur eine mögliche Variation dieser Steuersignale C, D dar. Im allgemeinen werden während des Umsteuerzeitintervalls die Steuersignale C, D als Impulssignale mit komplementär zueinander allmählich verändertem Tastverhältnis zwischen ihren zeitlichen konstanten Zuständen ausgestaltet. Es zeigt sich jedoch, daß der Schaltungsaufwand für die Erzeugung von impulsförmigen Steuersignalen C, D mit konstanter Impulsfrequenz und variablem Tastverhältnis beträchtlich höher ist. Demgegenüber ist der Schaltungsaufwand für die Erzeugung von Impulsen konstanter Dauer und variabler Wiederholungsfrequenz wesentlich geringer.

Auf die genannte Weise wird somit während des Umsteuerzeitintervalls quasi kontinuierlich zwischen den Eingangssignalen A und B übergeblendet. Der sich am Ausgang 1 einstellende Wert des Ausgangssignals entspricht einem gewichteten Mittel bzw. einer Liniarkombination der Signalwerte der beiden Eingangssignale A und B, wobei die Gewichtung bzw. die Parameter für die Liniarkombination sich aus dem Augenblickswert des Tastverhältnisses (bzw. entsprechend der Pulsdichte bzw. Pulsfrequenz und der Pulsdauer) ergeben. Am gemeinsamen Verbindungspunkt 11 entsteht somit im Umsteuerzeitintervall ein impulsförmig zwischen den Werten der beiden Eingangssignale A und B hin- und hergeschaltetes Signal, welches in der nachgeschalteten Integrationsanordnung geglättet wird.

Mit der beschriebenen Schaltungsanordnung kann außer einem Umsteuervorgang der dargestellten Art auch eine zeitlich konstante Verknüpfung bzw. Liniarkombination der beiden Eingangssignale A und B vorgenommen werden, so daß als Ausgangssignal am Ausgang 1 ein Signal mit einem Signalwert erscheint, der ein zeitlich konstant gewichtetes Mittel zwischen den Werten der genannten Eingangssignale darstellt. Beim voraufgehend beschriebenen Umsteuervorgang wird sich jedoch das Ausgangssignal kontinuierlich vom Wert des einen Eingangssignals A bzw. B auf den Wert des anderen Eingangssignals B bzw. A ändern.

Die schematische Schaltungsanordnung aus Fig. 1, die vorzugsweise zur Amplitudeneinstellung eines an den Endanschlüssen 7, 8 des ohmschen Spannungsteilers anliegenden Signals dient, welches insbesondere ein Audiosignal sein kann, läßt sich entsprechend der gewünschten Amplitudenabstufung dieses Signals um weitere ohmsche Widerstände im ohmschen Spannungsteiler und entsprechend um weitere steuerbare Schalter für jeden weiteren Abgriff zwischen je zwei ohmschen Widerständen erweitern. Dabei können alle steuerbaren Schalter an den gemeinsamen Verbindungspunkt 11 angeschlossen sein.

Eine solche Erweiterung der Schaltungsanordnung nach Fig. 1 ist insbesondere mit steuerbaren Schaltern sehr einfach und effektiv möglich, die als bidirektionale Schalter mit komplementären MOS-Feldeffekttransistoren nach dem sogenannten BIMOS-Herstellungsprozeß gefertigt sind. Bei einem Einsatz derartig ausgebildeter steuerbarer Schalter erübrigt sich die Verwendung von Operationsverstärkern mit Vielfacheingängen, wie sie in der DE 32 00 071 A1 beschrieben sind. Dadurch wird die Zahl der benötigten Operationsverstärker und insgesamt der benötigten Schaltungsbauteile merklich verringert. Somit wird bei einem Aufbau als integrierte Schaltungsanordnung auch nur eine geringere Kristallfläche benötigt, und die derart ausgebildete Schaltungsanordnung zeigt eine geringere Leistungsaufnahme bei verbesserter Rauschcharakteristik. Durch den sogenannten BIMOS-Prozeß werden außerdem Widerstände mit wesentlich verringerter Spannungsabhängigkeit verfügbar, wodurch die Entstehung harmonischer Verzerrungen (Klirrfaktor) in der Schaltungsanordnung vermindert werden kann. Die Einsparung an Leistungsaufnahme und Kristallfläche gilt im übrigen auch für logische Gatter, die im Zusammenhang mit der erfindungsgemäßen Schaltungsanordnung auf der integrierten Halbleiterschaltung angeordnet werden.

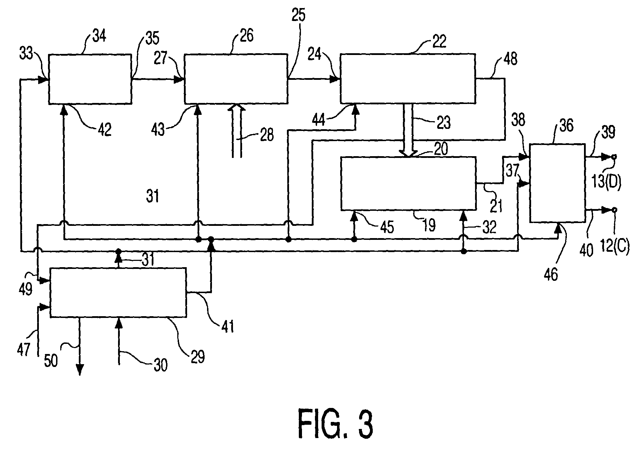

Fig. 3 zeigt blockschematisch eine Steueranordnung zum Erzeugen der Steuersignale C, D, die den Steueranschlüssen 12, 13 der steuerbaren Schalter 9, 10 in Fig. 1 zugeführt werden und durch die diese steuerbaren Schalter 9, 10 zueinander komplementär hin- und hergeschaltet werden. Das in Fig. 3 dargestellte Ausführungsbeispiel dieser Steueranordnung stellt eine besonders vorteilhafte Ausbildung eines Pulsdichte- bzw. Pulsfrequenzmodulators dar. Als Kernstück der Steueranordnung dient eine Akkumulationsschaltung 19, die einen Eingang 20 für ein aufzuakkumulierendes Signal und einen Ausgang 21 zur Abgabe eines Übertragssignals aufweist. Die Akkumulationsschaltung 19 kann in an sich bekannter Weise durch eine über ein Speicherregister rückgekoppelte Addierschaltung gebildet sein. Der Eingang 20 der Akkumulationsschaltung 19 ist mit einem Ausgang 23 einer Zählerstufe 22 verbunden. Über diese Verbindung werden dem Eingang 20 der Akkumulationsschaltung 19 Ausgangsdatensignale der Zählerstufe 22, die deren aktuelle Zählerstellung wiedergeben, als aufzuakkumulierende Signale zugeführt. Für eine Verwendung der erfindungsgemäßen Schaltungsanordnung in einem Gerät zur Audiosignalverarbeitung weisen die Akkumulationsschaltung 19 und die Zählerstufe 22 eine Wortbreite von vorzugsweise 9 Bit oder mehr auf. Dabei stimmt die Wortbreite der Akkumulationsschaltung 19 mit derjenigen der Zählerstufe 22 überein. Im Falle einer Wortbreite von 9 Bit umfaßt die Zählerstufe 22 somit 512 Zählschritte.

Ein Taktsignaleingang 24 der Zählerstufe 22 ist mir einem Ausgang 25 einer einstellbaren Taktfrequenzteilerstufe 26 verbunden. Die einstellbare Taktfrequenzteilerstufe 26 weist weiterhin einen Eingang 27 für ein Taktsignal auf. Sie umfaßt weiterhin einen Einstellsignaleingang 28, über die ein digitales Einstellsignal zum Einstellen des Frequenzteilerfaktors zuführbar ist, mit dem in der einstellbaren Taktfrequenzteilerstufe die Frequenz des dem Eingang 27 zugeführten Taktsignals geteilt wird, um ein über den Ausgang 25 abgeleitetes, frequenzgeteiltes Signal zum Zuführen an die Zählerstufe 22 über deren Taktsignaleingang 24 zu erhalten.

Die Steueranordnung nach Fig. 3 umfaßt weiterhin eine Logikstufe 29, die der Steuerung der Funktionsabläufe in der Steueranordnung dient. Der Logikstufe wird an einem Taktsignaleingang 30 von einer nicht dargestellten Taktsignalquelle ein Grundtaktsignal zugeführt. In der Logikstufe 29 wird aus diesem Grundtaktsignal ein Akkumulatortaktsignal abgeleitet, welches vorzugsweise dieselbe Frequenz wie das Grundtaktsignal aufweisen kann, jedoch auch aus diesem durch Frequenzteilung oder dergleichen gebildet werden kann. Dieses Akkumulatortaktsignal wird an einem Ausgang 31 der Logikstufe 29 abgegeben. Vom Ausgang 31 der Logikstufe 29 wird das Akkumulatortaktsignal einem Taktsignaleingang 32 der Akkumulationsschaltung 19 zugeführt sowie andererseits einem Eingang 33 eines Frequenzvorteilers 34, in dem aus dem Akkumulatortaktsignal durch Frequenzteilung um einen vorgegebenen Teilerfaktor das Taktsignal gebildet wird, welches über einen Ausgang 35 vom Frequenzvorteiler 34 an den Eingang 27 der einstellbaren Taktfrequenzteilerstufe 26 geliefert wird. Im Gegensatz zur einstellbaren Taktfrequenzteilerstufe 26 ist der Teilerfaktor des Frequenzvorteilers 34 fest.

Mit dem Akkumulatortaktsignal vom Ausgang 31 der Logikstufe 29 wird außerdem eine bistabile D-Kippstufe 36 an ihrem Takteingang 37 getaktet. Ein Dateneingang (D-Eingang) 38 der bistabilen D-Kippstufe 36 ist mit dem Ausgang 21 der Akkumulationsschaltung 19 für deren Übertragssignal verbunden. Somit wird, getaktet durch das Akkumulatortaktsignal, der Schaltzustand der bistabilen D-Kippstufe 36 durch den Wert des Übertragssignals aus der Akkumulationsschaltung 19 bestimmt. Ein Q-Ausgang 39 der bistabilen D-Kippstufe 36 ist mit dem Steueranschluß 13 des zweiten steuerbaren Schalters 10 verbunden und liefert das zweite Steuersignal D, wohingegen ein invertierender Q-Ausgang 40 der bistabilen D-Kippstufe 36 mit dem Steueranschluß 12 des ersten steuerbaren Schalters 9 verbunden ist und das erste Steuersignal C liefert.

Im vorliegenden Ausführungsbeispiel nach Fig. 3 ist die gezeigte Steueranordnung für das Umsteuern des Ausgangs 1 zwischen dem ersten Eingang 2 und dem zweiten Eingang 3 innerhalb eines Umsteuerzeitintervalls vorgebbarer Dauer ausgestaltet. Zur Erläuterung der Funktionsweise der Steueranordnung wird der in der mittleren Zeile der Tabelle nach Fig. 2 schematisch dargestellte Fall des Umsteuerns vom ersten Eingangssignal A zum zweiten Eingangssignal B vorausgesetzt. Zu Beginn des Umsteuerzeitintervalls muß somit das erste Steuersignal C einen zeitlich konstanten hohen logischen P aufweisen, wohingegen sich das zweite Steuersignal D zeitlich konstant auf niedrigem logischem Pegel L befindet. Um diesen Zustand definiert einnehmen zu können, wird von der Logikstufe 29 außerhalb des Umsteuerzeitintervalls ein Rücksetzsignal erzeugt und an einem Rücksetzausgang 41 abgegeben. Über Rückserzeingänge 42, 43, 44, 45 bzw. 46 des Frequenzvorteilers 34, der einstellbaren Taktfrequenzteilerstufe 26, der Zählerstufe 22, der Akkumulationsschaltung 19 bzw. der bistabilen D-Kippstufe 36 werden diese Stufen außerhalb des Umsteuerzeitintervalls durch das Rücksetzsignal in einen definierten Anfangszustand überführt und in diesem gehalten, bis der Logikstufe 29 als Befehlssignal für das Auslösen eines Umsteuervorgangs an einem Starteingang 47 ein Startsignal zugeführt wird. Von der Logikstufe 29 wird dann das Rücksetzsignal unterbrochen und werden die genannten Stufen freigegeben. In diesem ersten Augenblick nach Beendigung des Rücksetzsignals befinden sich die Akkumulationsschaltung 19 und die Zählerstufe 22 in ihrem Anfangszustand, d.h. in der Zählerstellung 0 bzw. bei einem aufakkumulierten Wert 0.

Mit dem Akkumulatortaktsignal wird nun einerseits die Akkumulationsschaltung 19 getaktet, andererseits wird durch Frequenzteilung in der einstellbaren Taktfrequenzteilerstufe 26 und dem Frequenzvorteiler 34 daraus das Taktsignal für den Taktsignaleingang 24 der Zählerstufe 22 abgeleitet. Die Akkumulationsschaltung 19 beginnt somit, im Takt des Akkumulatortaktsignals die vom Ausgang 23 der Zählerstufe 22 dem Eingang 20 zugeführten Werte des Ausgangsdatensignals aufzuakkumulieren. Bis zum Eintreffen des ersten Impulses des Taktsignals am Taktsignaleingang 24 wird von der Akkumulationsschaltung 19 der Wert 0 aufakkumuliert, so daß sich der Inhalt, d.h. der in der Akkumulationsschaltung 19 gespeicherte Wert zunächst nicht ändert. Nach Eintreffen des ersten Impulses des Taktsignals am Taktsignaleingang 24 schaltet die Zählerstufe 22 um einen Zählschritt weiter und das Ausgangsdatensignal am Ausgang 23 nimmt den binären Wert 1 an. Im folgenden werden nun von der Akkumulationsschaltung 19 in jeder Periode des Akkumulatortaktsignals die jeweils aktuellen Werte, die in der Akkumulationsschaltung 19 gespeichert sind, um diesen binären Wert 1 erhöht. Ohne einen weiteren Impuls am Taktsignaleingang 24 und bei einer Wortbreite von 9 Bit wird somit die Akkumulationsschaltung nach 512 Perioden des Akkumulatortaktsignals an ihrem Ausgang 21 ein Übertragssignal abgeben, welches genau eine Periodendauer des Akkumulatortaktsignals andauert. Dieses Übertragssignal gelangt an den Dateneingang 38 der bistabilen D-Kippstufe 36 und wird mit dem zeitgleich auftretenden Impuls des Akkumulatortaktsignals am Takteingang 37 in die bistabile D-Kippstufe 36 geladen. In der nächsten Periode des Akkumulatortaktsignals ist das Übertragssignal am Ausgang 21 wieder beendet, und die bistabile D-Kippstufe 36 wird in den vorher innegehabten Zustand zurückgeschaltet. Das bedeutet, daß durch das Übertragssignal am Ausgang 21 der Akkumulationsschaltung 19 an den die Steuersignale CD abgebenden Ausgängen 40 bzw. 39 Impulse von der Dauer einer Periode des Akkumulatortaktsignals auftreten, und zwar am invertierenden Q-Ausgang 40 negative Impulse vom hohen logischen Pegel H zum niedrigen logischen Pegel L und am Q-Ausgang 39 umgekehrt.

Die beschriebenen Signale wiederholen sich, so lange am Taktsignaleingang 24 kein weiterer Impuls eintrifft, um die Zählerstufe um einen Zählschritt weiterzuschalten. Der Zeitpunkt, zu dem dies eintritt, hängt von dem Frequenzteilerfaktor ab, auf den die einstellbare Taktfrequenzteilerstufe 26 über ihren Einstellsignaleingang 28 eingestellt ist.

Nach dem Umschalten wird von der Zählerstufe 22 über ihren Ausgang 23 ein den binären Wert 2 darstellendes Ausgangsdatensignal an den Eingang 20 der Akkumulationsschaltung 19 gegeben. Somit wird im folgenden von der Akkumulationsschaltung 19 dieser binäre 2 aufakkumuliert. Bei einer Beharrung der Zählerstufe 22 in diesem Zustand tritt dann am Ausgang 21 der Akkumulationsschaltung alle 256 Perioden des Akkumulatortaktsignals ein Übertragssignal auf, d.h. ein Impuls in den Steuersignalen an den Ausgängen 39, 40 der bistabilen D-Kippstufe 36. Die Dauer der Impulse in den Steuersignalen C bzw. D bleibt somit unverändet, jedoch erhöht sich ihre Wiederholungsfrequenz.

Dieser Vorgang setzt sich weiter fort, wenn weitere Impulse des Taktsignals am Taktsignaleingang 24 der Zählerstufe 22 eintreffen und diese um eine entsprechende Anzahl von Zählschritten weiterschalten. Entsprechend wird der damit sich Zählschritt für Zählschritt erhöhende Wert des Ausgangsdatensignals in der Akkumulationsschaltung 19 aufakkumuliert, und entsprechend häufiger wird am Asugang 21 ein Übertragssignal abgegeben. Dieses tritt beispielsweise bei einer Zählerstellung der Zählerstufe 22, d.h. bei einem Ausgangsdatensignal mit einem binären Wert 3 und der genannten Wortbreite von 9 Bit nach etwa jeweils 170 Perioden des Akkumulatortaktsignals auf. Bei einem Ausgangsdatensignal mit einem binären 4 verkürzt sich dieser zeitliche Abstand, d.h. die Wiederholungsfrequenz der Impulse der Steuersignale auf 128 Periodendauern des Akkumulatortaktsignals usw. Von Zählschritt zu Zählschritt der Zählerstufe 22 nimmt somit die Wiederholfrequenz der Impulse in den von der bistabilen D-Kippstufe 36 abgegebenen Steuersignale C, D zu. Wenn die aktuelle Zählerstellung der Zählerstufe 22 der halben Gesamtzahl der möglichen Zählschritte der Zählerstufe 22 entspricht, wenn also beispielsweise bei einer Wortbreite von 9 Bit der Zählerstufe 22 das Ausgangsdatensignal den Wen 256 annimmt, wird in den Steuersignalen C, D in jeder zweiten Periode des Akkumulatortaktsignals ein Impuls erzeugt. Die Wiederholfrequenz der Impulse in den Steuersignalen C, D erreicht dann ihren höchsten Wen. Bis zu diesem Zustand ist die Wiederholfrequenz der Impulse im Übertragssignal am Ausgang 21 der Akkumulationsschaltung 19 und damit in den Steuersignalen C, D ein direktes Maß des Wertes des Ausgangsdatensignals am Ausgang 23 der Zählerstufe 22.

Durch weitere Impulse des Taktsignals am Taktsignaleingang 24 werden weitere Zählschritte ausgelöst, durch die auch der Wert des Ausgangsdatensignals sich weiter erhöht. Die Anzahl der Impulse im Übertragssignal am Ausgang 21 der Akkumulationsschaltung 19 nimmt dann weiter zu. Dabei treten Fälle auf, in denen das Übertragssignal in zwei und später mehreren aufeinanderfolgenden Perioden des Akkumulatortaktsignals einen Überlauf der Akkumulationsschaltung 19 anzeigt. Dadurch werden in den Steuersignalen C, D unmittelbar aneinander anschließende Impulse ohne zwischengeschaltete Flanken erzeugt. Das bedeutet, daß die Steuersignale C, D mehr und mehr in längeren Zeitintervallen kontinuierlich den logischen Pegel annehmen, der zu Beginn des Umsteuerns lediglich in den vereinzelten Impulsen auftrat. Dieser Vorgang ist gleichbedeutend mit einer wieder abnehmenden Impulsfrequenz der impulsförmigen Steuersignale C, D.

Der Umsteuervorgang ist beendet, wenn die Zählerstufe 22 ihre Endstellung erreicht hat. In dieser Stellung wird in jeder Periode des Akkumulatortaktsignals am Ausgang 21 ein Übertragssignal erzeugt, wodurch sich für die Steuersignale C, D konstante logische Pegel ergeben. Außerdem wird an einem Übertragsausgang 48 der Zählerstufe 22 auch von dieser ein Übertragssignal abgegeben, welches einem Stoppeingang 49 der Logikstufe 29 als Stoppsignal zugeleitet wird. Durch dieses Stoppsignal wird die Steueranordnung nach Fig. 3 in dem letztbeschriebenen Zustand angehalten, insbesondere durch Unterbrechen des Akkumulatortaktsignals am Ausgang 31. Über einen Meldeausgang 50 kann die Beendigung des Umsteuervorgangs auch an Steuerungen außerhalb der beschriebenen Anordnung weiter gemeldet werden.

Der Frequenzteilerfaktor der einstellbaren Taktfrequenzteilerstufe 26 ist durch das digitale Einsteilsignal über den Einstellsignaleingang 28 innerhalb vorgebbarer Wertebereiche einstellbar, beispielsweise zwischen 1 und 32. Je größer der Frequenzteilerfaktor gewählt wird, desto niedriger ist die Frequenz des dem Taktsignaleingang 24 der Zählerstufe 22 zugeführten Taktsignals im Verhältnis zur Frequenz des Akkumulatortaktsignals. Dadurch werden die Zählschritte der Zählerstufe 22 langsamer durchlaufen, je höher der Frequenzteilerfaktor gewählt wird. Dies resultiert in einer größeren Dauer des Umsteuerzeitintervalls, die sich über das Einsteilsignal bestimmen läßt.

Zum Erreichen eines möglichst störungsfreien Betriebes der erfindungsgemäßen Schaltungsanordnung werden sowohl für die Pulsdichte bzw. Pulsfrequenz der Steuersignale C, D als auch für die Wiederholungsfrequenz der Schritte des schrittweisen Änderns der Pulsdichte bzw. Pulsfrequenz der Steuersignale C, D ausschließlich Frequenzen außerhalb des hörbaren Frequenzbereichs verwendet, wenn die erfindungsgemäße Schaltungsanordnung zur Audiosignalverarbeitung eingesetzt werden soll. Dies bestimmt entscheidend die Wahl der Frequenz des Akkumulatortaktsignals, der Wortbreite der Zählerstufe 22 und der Akkumulationsschaltung 19, des Frequenzteilerfaktors der einstellbaren Taktfrequenzteilerstufe 26 sowie des Teilerfaktors des Frequenzvorteilers 34. Auch sind hohe Pulsfrequenzen in den Steuersignalen C, D erwünscht, um den Schaltungsaufwand für die Integrationsanordnung 18 gering halten zu können.

Speziell für ein Ausführungsbeispiel einer erfindungsgemäßen Schaltungsanordnung zur Lautstärkesteuerung eines Audiosignals wird gefordert, daß die Pulsfrequenz der Steuersignale C, D stets mehr als 20 kHz betragen muß, um nicht mehr hörbar zu sein. Vorteilhaft sind jedoch Werte oberhalb 100 kHz. Des weiteren wird gefordert, daß die Dauer der Umsteuerzeitintervalle zwischen einem Wert unterhalb einer Millisekunde und einem Wert oberhalb von 20 msec eingestellt werden kann. Ferner wird, wie im vorstehenden bereits erläutert wurde, das Tastverhältnis für die Steuersignale C, D zwischen 0 und 100 % innerhalb eines Umsteuerzeitintervalls variiert. Aus Hörproben hat sich ergeben, daß nicht nur die Pulsfrequenz der Steuersignale C, D, sondern auch die Wiederholungsfrequenz der Veränderung der Pulsdichte bzw. Pulsfrequenz der Steuersignale C, D, d.h. die Wiederholfrequenz der Änderungen der Wiederholfrequenz der Impulse im Übertragssignal am Ausgang 21 der Akkumulationsschaltung 19, einen Wert oberhalb von 16 kHz annehmen muß. Daraus folgt, daß für den größten vorgebbaren Wert der Dauer des Umsteuerzeitintervalls von wenigstens 20 msec das Tastverhältnis der Steuersignale C, D in wenigstens 400 Schritten zwischen 0 und 100 % änderbar sein muß, um diese Schritte nicht mehr hörbar sein zu lassen. Wenn zwischen den Eingangssignalen A, B ein Pegelunterschied von 1 dB besteht, wird somit während des Umsteuervorgangs der Pegel in Schritten von weniger als 0,0025 dB verändert.

Für dasselbe Ausführungsbeispiel hat sich weiter ergeben, daß die Frequenz des Grundtaktsignals einen Wert von 4,5 MHz nicht überschreiten sollte. Vorteilhaft ist eine Festlegung der Frequenz des Grundtaktsignals auf 4,332 MHz. Diese Frequenz läßt sich aus der Anwendung eines RDS-Dekoders ableiten. Aus ihr ist außerdem durch Teilung um den Faktor 114 die Stereoreferenzfrequenz für die Stereodekoder-PLL von 38 kHz ableitbar.

Für eine gemäß diesem Ausführungsbeispiel dimensionierte Steueranordnung nach Fig. 3 werden 3-Bit-Frequenzvorteiler 34 und eine 5-Bit-Taktfrequenzteilerstufe 26 gewählt.

Damit ist der Frequenzteilerfaktor der einstellbaren Taktfrequenzteilerstufe 26 zwischen dem Wert 1 und dem Wert 32 einstellbar, wohingegen der Teilerfaktor des Frequenzvorteilers 34 mit dem Wert 8 fest vorgegeben ist. Mit den vorstehend genannten Zahlenwerten ergibt sich daraus eine Dauer des Umsteuerzeitintervalls zwischen 30,3 msec und 0,95 msec. Dabei wird die bereits genannte Wortbreite für die Zählerstufe 22 und die Akkumulationsschaltung 19 von 9 Bit vorausgesetzt sowie angenommen, daß die Frequenz des Akkumulatortaktsignals mit der Frequenz des Grundtaktsignals übereinstimmt.

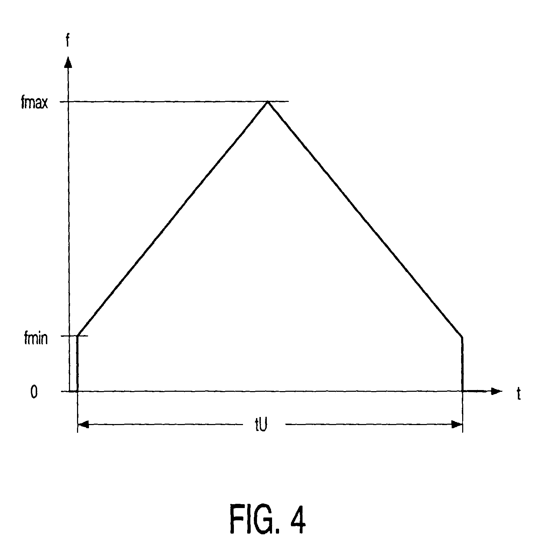

In Fig. 4 ist schematisch die Änderung der Pulsfrequenz f der Steuersignale C, D im Verlaufeines Umsteuerzeitintervalls der Dauer tU über der Zeit t aufgetragen. Mit dem ersten Impuls des Taktsignals am Taktsignaleingang 24 der Zählerstufe 22 springt die Pulsfrequenz f der Steuersignale C, D von 0 auf den Wert fmin, der im Ausführungsbeispiel mit der vorstehend aufgelisteten Dimensionierung 8,46 kHz beträgt. Mit zunehmendem Wert des Ausgangsdatensignals von der Zählerstufe 22 steigt die Pulsfrequenz f zur Mitte des Umsteuerzeitintervalls tU aufeinen maximalen Wert fmax von 2,17 MHz, der halben Frequenz des Akkumulatortaktsignals. Von diesem Zeitpunkt an fällt, wie beschrieben, die Pulsfrequenz f zurück auf den minimalen Wert fmin von 8,46 kHz beim Auftreten des zweithöchsten Wertes des Ausgangsdatensignals am Ausgang 23, d.h. des Wertes, den dieses Ausgangsdatensignal vor dem letzten Zählschritt annimmt, durch den das Übertragssignal am Übertragsausgang 48 der Zählerstufe 22 ausgelöst wird. Anschließend fällt die Frequenz der Steuersignale C, D wieder auf Null, d.h. die Steuersignale C, D nehmen konstante Werte an.

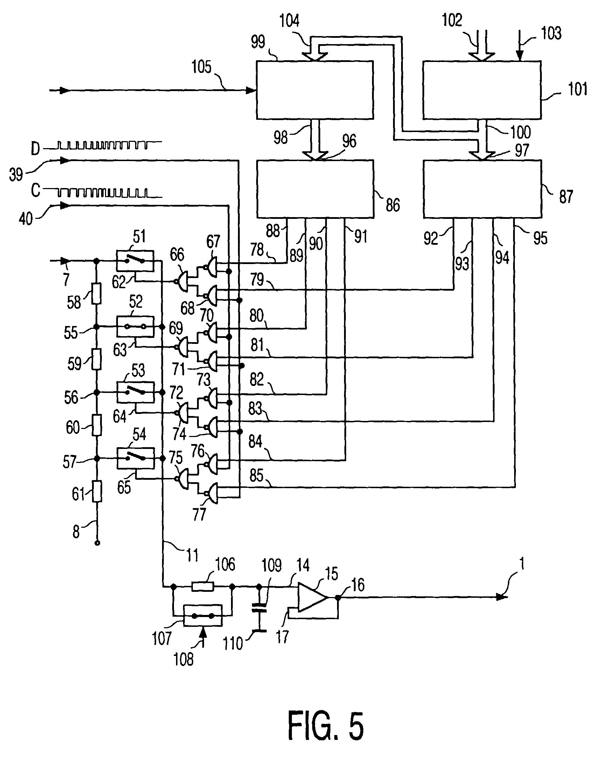

Fig. 5 zeigt ein Ausführungsbeispiel für eine Ablaufsteuerstufe, die zusammen mit den in Fig. 3 dargestellten Elementen Teil der Steueranordnung ist. In Abwandlung der in Fig. 1 beschriebenen Schaltungsanordnung werden in Fig. 5 Aufbau und Funktionsweise der Ablaufsteuerstufe an einem Ausführungsbeispiel mit vier steuerbaren Schaltern 51, 52, 53 bzw. 54 beschrieben, die jedoch für sich jeder vollkommen den steuerbaren Schaltern 9, 10 aus Fig. 1 entsprechen. Wie in Fig. 1 sind auch in Fig. 5 die steuerbaren Schalter 51, 52, 53, 54 einseitig mit einem gemeinsamen Verbindungspunkt 11 und andererseits mit je einem Anzapfungspunkt 55, 56 bzw. 57 bzw. mit dem ersten Endanschluß 7 eines ohmschen Spannungsteilers aus ohmschen Widerständen 58, 59, 60, 61 verbunden. Der gemeinsame Verbindungspunkt 11 ist wiederum über einen Operationsverstärker 15 mit dem Ausgang gekoppelt.

Die Ablaufsteuerstufe gemäß Fig. 5 enthält ferner Gatterschaltungen, über die die Ausgänge 39, 40 der bistabilen D-Kippstufe 36 für die Steuersignale C, D wahlweise mit Steueranschlüssen 62, 63, 64 bzw. 65 der steuerbaren Schalter 51, 52, 53 bzw. 54 verbindbar sind. Diese Gatterschaltungen sind derart angeordnet, daß zu jedem der Steueranschlüsse 62, 63, 64, 65 eine Gruppe aus drei NAND-Gattern 66 bis 68, 69 bis 71, 72 bis 74 bzw. 75 bis 77 zugeordnet ist. In jeder der Gruppen von NAND-Gattern 66 bis 68, 69 bis 71, 72 bis 74 bzw. 75 bis 77 sind die Eingänge des ersten NAND-Gatters 66, 69, 72 bzw. 75 mit dem Ausgang je eines der übrigen NAND-Gatter 67, 68 bzw. 70, 71 bzw. 73, 74 bzw. 76, 77 der Gruppe von NAND-Gattern verbunden. Die Ausgänge der ersten NAND-Gatter 66, 69, 72 bzw. 75 sind mit den Steueranschlüssen 62, 63, 64 bzw. 65 der zugeordneten steuerbaren Schalter 51, 52, 53 bzw. 54 verbunden. Ein Eingang jedes zweiten NAND-Gatters 67, 70, 73 bzw. 76 der Gruppen von NAND-Gattern ist mit dem invertierenden Q-Ausgang 40 der bistabilen D-Kippstufe 36 zum Zuführen des ersten Steuersignals C verbunden. Je ein Eingang der dritten NAND-Gatter 68, 71, 74 bzw. 77 der Gruppen von NAND-Gattern ist mir dem Q-Ausgang 39 der bistabilen D-Kippstufe 36 für das zweite Steuersignal D verbunden. Die zweiten Eingänge der zweiten und dritten NAND-Gatter 67, 68 bzw. 70, 71 bzw. 73, 74 bzw. 76, 77 der Gruppen von NAND-Gattern bilden erste Anschlüsse 78, 80, 82, 84 bzw. zweite Anschlüsse 79, 81, 83, 85 der Gruppen von NAND-Gattern 66 bis 77. Über die Anschlüsse 78 bis 85 können Signale zugeführt werden, über die durch die Gruppen von NAND-Gattern 66 bis 77 bestimmte der steuerbaren Schalter 51 bis 54 auswählbar sind, um ihnen die Steuersignale C bzw. D zuzuführen, während die übrigen der steuerbaren Schalter 51 bis 54 in ihrem gesperrten Zustand verbleiben.

Diese Auswahl der steuerbaren Schalter 51, 52, 53 bzw. 54 über die NAND-Gatter 66 bis 77 erfolgt von Dekodierstufen 86 bzw. 87 aus, die im Ausführungsbeispiel nach Fig. 5 als 1-Aus-4-Dekoder mit vier Ausgängen 88, 89, 90, 91 bzw. 92, 93, 94, 95 ausgebildet sind. Den Dekodierstufen 86 bzw. 87 werden über Eingänge 96 bzw. 97 Datenworte zugeführt, die im Ausführungsbeispiel nach Fig. 5 eine Wortbreite von 2 Bit aufweisen. Je nach binärem Wert dieser Datenworte wird einer der Ausgänge 88 bis 91 bzw. 92 bis 95 der Dekodierstufen 86 bzw. 87 auf einen hohen logischen Pegel H geschaltet, wohingegen die übrigen der Ausgänge 88 bis 91 bzw. 92 bis 95 auf niedrigem logischem Pegel L liegen. Die Ausgänge 88 bis 91 der ersten Dekodierstufe 86 sind dabei mit den ersten Anschlüssen 78, 80, 82 bzw. 84 der ersten, zweiten, dritten bzw. vierten Gruppe von NAND-Gattern verbunden. Die Ausgänge 92, 93, 94, 95 der zweiten Dekodierstufe 87 sind mir den zweiten Anschlüssen 79, 81, 83 bzw. 85 der zweiten, dritten bzw. vierten Gruppe von NAND-Gattern verbunden. Somit wird durch die erste Dekodierstufe 86 die Zufuhr des ersten Steuersignals C zu einem der steuerbaren Schalter 51 bis 54 ausgewählt, wohingegen durch die zweite Dekodierstufe 87 die Zufuhr des zweiten Steuersignals D zu einem dieser steuerbaren Schalter 51 bis 54 auswählbar ist.

Der Eingang 96 der ersten Dekodierstufe 86 ist mit einem Ausgang 98 eines ersten Zustandspeicherelements verbunden. Entsprechend ist der Eingang 97 der zweiten Dekodierstufe 87 mir einem Ausgang 100 eines zweiten Zustandsspeicherelements 101 verbunden. Das erste Zustandsspeicherelement 99 dient zum Speichern eines Informationssignals für einen Anfangszustand eines Umsteuervorgangs, d.h. zur Angabe desjenigen der steuerbaren Schalter 51, 52, 53 bzw. 54 der in diesem Anfangszustand dauerhaft leitend ist. Das zweite Zustandsspeicherelement 101 speichert ein Informationssignal für den Endzustand des Umsteuervorgangs, d.h. für denjenigen der steuerbaren Schalter 51, 52, 53 bzw. 54, der im Endzustand leitend ist. Diese Informationssignale werden im Ausführungsbeispiel nach Fig. 5 durch die Datenworte von zwei Bit Wortbreite gebildet, die in den Dekodierstufen 86, 87 dekodiert werden. Dabei wird das Informationssignal für den Endzustand über einen Buseingang 102 in das zweite Zustandsspeicherelement 101 geladen, wenn gleichzeitig ein entsprechendes Ladesignal über einen Ladesignaleingang 103 dem zweiten Zustandsspeicherelement 101 zugeführt wird. Außerdem ist der Ausgang 100 des ersten Zustandsspeicherelements 99 mit einem Eingang 104 des ersten Zustandsspeicherelements 99 verbunden. Über diese Verbindung kann bei Zufuhr eines weiteren Ladesignals über einen Ladesignaleingang 105 des ersten Zustandsspeicherelements 99 das Informationssignal für den Endzustand aus dem zweiten Zustandsspeicherelement 101 in das erste Zustandsspeicherelement 99 umgeladen werden.

Vor Beginn eines Umsteuervorgangs hat das erste Steuersignal C einen hohen logischen Pegel H angenommen, wohingegen das zweite Steuersignal D einen niedrigen logischen Pegel L innehat. Die Ausgänge der dritten NAND-Gatter 68, 71, 74 und 77 der Gruppen von NAND-Gattern befinden sich dann auf hohem logischem Potential H, da das zweite Steuersignal D den Pegel L innehat. Somit haben die Signale von den Ausgängen 92, 93, 94, 95 der zweiten Dekodierstufe 87 keinen Einfluß auf die steuerbaren Schalter 51, 52, 53, 54, d.h. auch das im zweiten Zustandsspeicherelement 101 gespeicherte Infomationssignal für den Endzustand hat auf die steuerbaren Schalter 51 bis 54 keinen Einfluß. Somit können in das zweite Zustandsspeicherelement 101 ohne Beeinflussung des Ausgangssignals am Ausgang 1 neue Informationssignale eingespeichert ohne daß dadurch hervorgerufene Störungen auf den Ausgängen 92 bis 95 sich auswirken können.

Im Gegensatz dazu befindet sich das erste Steuersignal C auf hohem logischem Pegel H, wodurch die zweiten NAND-Gatter 67, 70, 73 und 76 aller Gruppen von NAND-Gattern zum Durchleiten der Signale von den Ausgängen 88 bis 91 der ersten Dekodierstufe 86 freigeschaltet sind. Damit kann das Informationssignal für den Anfangszustand, welches im ersten Zustandsspeicherelement 99 gespeichert ist, über die erste Dekodierstufe 86 und die Gatterschaltungen 66 bis 77 Einfluß auf die Zustände der steuerbaren Schalter 51 bis 54 nehmen.

Es sei der Fall angenommen, daß im ersten Zustandsspeicherelement 99 ein Datenwort gespeichert ist, welches einen binär kodierten Wert 1 repräsentiert. Das bedeutet, daß der zweite Ausgang 89 der ersten Dekodierstufe 86 einen hohen logischen Pegel H führt, wohingegen der erste, dritte und vierte Ausgang 88, 90, 91 der ersten Dekodierstufe 86 einen niedrigen logischen Pegel L führen. Somit erhält der erste Anschluß 80 der zweiten Gruppe von NAND-Gattern einen hohen logischen Pegel H zugeführt. Als Folge davon nimmt der Ausgang des zweiten NAND-Gatters 70 der zweiten Gruppe von NAND-Gattern einen niedrigen logischen Pegel L an. Dadurch wird der Ausgang des ersten NAND-Gatters dieser zweiten Gruppe von NAND-Gattern auf hohen logischen Pegel H gebracht und damit der zweite steuerbare Schalter 52 in seinen leitenden Zustand überführt, wie dies in der Fig. 5 angedeutet ist. Da die zweiten und dritten NAND-Gatter 67, 68, 73, 74, 76, 77 an ihren Ausgängen in diesem Betriebszustand übereinstimmend hohe logische Pegel H aufweisen, denn je wenigstens einer ihrer Eingänge weist einen niedrigen logischen Pegel L auf, befinden sich die Ausgänge der ersten NAND-Gatter 66, 72, 75 der ersten, dritten und vierten Gruppe von NAND-Gattern auf niedrigem logischem Pegel L. Somit wird das Ausgangssignal am Ausgang 1 von dem ersten Anzapfungspunkt 55 des ohmschen Spannungsteilers 58 bis 61 abgegriffen.

Nachdem über den Buseingang 102 ein Informationssignal für einen neuen Endzustand zugeleitet und über das Ladesignal am Ladesignaleingang 103 in dem zweiten Zustandsspeicherelement 101 gespeichert worden und damit an dessen Ausgang 100 verfügbar ist, erhält der Starteingang 47 der Logikstufe 29 in Fig. 3 das Startsignal für den Umsteuervorgang zugeführt. Es sei der Fall beschrieben, daß das neu gespeicherte Informationssignal den binär kodierten Wert 3 aufweist. Am vierten Ausgang 95 der zweiten Dekodierstufe 87 erscheint dann ein hoher logischer Pegel H, wohingegen die übrigen Ausgänge 92 bis 94 der zweiten Dekodierstufe 87 auf niedrigem logischem Pegel L verbleiben. Damit wird über den zweiten Anschluß 85 der vierten Gruppe von NAND-Gattern das dritte NAND-Gatter 77 dieser vierten Gruppe von NAND-Gattern für eine Weiterleitung des zweiten Steuersignals D frei geschaltet. Alle übrigen dritten NAND-Gatter 68, 71, 74 jedoch über die zweiten Anschlüsse 79, 81, 83 der ersten, zweiten bzw. dritten Gruppe von NAND-Gattern gesperrt. Da das Signal am Ausgang des zweiten NAND-Gatters 76 der vierten Gruppe von NAND-Gattern aufgrund niedrigen logischen Pegels am ersten Anschluß 84 der vierten Gruppe von NAND-Gattern einen hohen logischen Pegel annimmt, wird am Steueranschluß 65 des vierten steuerbaren Schalters 54 im folgenden immer dann ein hoher logischer Pegel anliegen und wird damit immer dann der vierte steuerbare Schalter 54 leitend geschaltet, wenn der Ausgang des dritten NAND-Gatters 77 der vierten Gruppe von NAND-Gattern einen niedrigen logischen Pegel L annimmt. Dies geschieht immer dann, wenn das zweite Steuersignal D einen hohen logischen Pegel H erreicht. In denselben Zeitintervallen nimmt jedoch das erste Steuersignal C einen niedrigen logischen Pegel L an, so daß in diesen Zeitintervallen am Ausgang des zweiten NAND-Gatters 70 der zweiten Gruppe von NAND-Gattern ein hoher logischer Pegel H auftritt. Dies bedingt einen niedrigen logischen Pegel L in diesen Zeitintervallen an dem Steueranschluß 63 des zweiten steuerbaren Schalters 52, wodurch dieser gesperrt wird. In den genannten Zeitintervallen, die den in den Steuersignalen C, D auftretenden Impulsen entsprechen, schaltet somit die Anordnung den Ausgangsanschluß 1 (bzw. den gemeinsamen Verbindungspunkt 11) vom ersten Anzapfungspunkt 55 auf den dritten Anzapfungspunkt 57 des ohmschen Spannungsteilers 58 bis 61 um. Diese Umschaltung erfolgt mit den beschriebenen zeitlichen Verläufen der Steuersignale C, D in der Weise eines gestuften Überblendens vom ersten Anzapfungspunkt 55 zum dritten Anzapfungspunkt 57. Nach Abschluß des Umsteuervorgangs wird das Ausgangssignal für den Ausgang 1 zeitkontinuierlich vom dritten Anzapfungspunkt 57 abgegriffen.

In dem nun erreichten Zustand, in dem das erste Steuersignal C konstant einen niedrigen logischen Pegel L und das zweite Steuersignal D einen konstanten hohen logischen Pegel H annimmt, sind durch diese Werte der Steuersignale C. D alle steuerbaren Schalter 51 bis 54 von den Ausgängen 88 bis 91 der ersten Dekodierstufe 86 entkoppelt, so daß das Informationssignal für den Anfangszustand im ersten Zustandsspeicherelement 99 keinen Einfluß mehr auf das Ausgangssignal am Ausgang 1 ausübt. Daher kann jetzt mit dem weiteren Ladesignal am Ladesignaleingang 105 des ersten Zustandsspeicherelements 99 das Infomationssignal für den bisherigen Endzustand vom Ausgang 100 des zweiten Zustandsspeicherelements über dessen Verbindung mit dem Eingang 104 des ersten Zustandsspeicherelements 99 in dieses übernommen werden. Damit wird der bisherige Endzustand zum neuen Anfangszustand für einen folgenden Umsteuervorgang.

Mit diesem Ladevorgang nehmen die Ausgänge 88 bis 91 der ersten Dekodierstufe 86 dieselben logischen Pegel an wie die entsprechenden Ausgänge 92 bis 95 der zweiten Dekodierstufe 87. Damit wird der vierte steuerbare Schalter 54 außer über den vierten Ausgang 95 der zweiten Dekodierstufe 87, den zweiten Anschluß 85 der vierten Gruppe von NAND-Gattern und das dritte NAND-Gatter 77 der vierten Gruppe von NAND-Gattern auch über den vierten Ausgang 91 der ersten Dekodierstufe 86, den ersten Anschluß 84 der vierten Gruppe von NAND-Gattern und das zweite NAND-Gatter 76 der vierten Gruppe von NAND-Gattern zur Steuerung durch die Steuersignale C, D frei geschaltet. Da die Steuersignale C, D stets unterschiedliche logische Pegel aufweisen, wird somit der vierte steuerbare Schalter 54 stets entweder über das zweite NAND-Gatter 76 oder das dritte NAND-Gatter 77 der vierten Gruppe von NAND-Gattern im leitenden Zustand gehalten, unabhängig davon, welche Werte die Steuersignale C, D gerade annehmen. Daher kann nun das erste Steuersignal C auf seinen anfänglichen hohen logischen Pegel H und das zweite Steuersignal D auf seinen anfänglichen niedrigen logischen Pegel L zurückgeschaltet werden, ohne daß dies einen Einfluß auf das Ausgangssignal am Ausgang 1 hätte. Während dessen bleiben alle übrigen steuerbaren Schalter 51, 52, 53 unverändert gesperrt, da alle übrigen Ausgänge 88 bis 90, 92 bis 94 der Dekodierstufen 86, 87 auf niedrigem logischem Pegel L verbleiben. In dieser Weise wird die Schaltungsanordnung in einen Zustand überführt, der als Anfangszustand für einen in gleicher Weise ablaufenden weiteren Umsteuervorgang dient. Auch das zweite Zustandsspeicherelement 101 ist bereit zum Empfang eines neuen Infomationssignals für einen neuen Endzustand dieses folgenden Umsteuervorgangs.

Die Schaltungsanordnung nach Fig. 5 enthält in der Leitungsverbindung zwischen dem gemeinsamen Verbindungspunkt 11 und dem nicht invertierenden Eingang 14 des Operationsverstärkers 15 eine Anordnung aus einem Längswiderstand 106, der durch einen weiteren steuerbaren Schalter 107 überbrückbar ist. Über einen Steueranschluß 108 ist diesem weiteren steuerbaren Schalter 107 ein weiteres Steuersignal zuführbar. Vom Verbindungspunkt zwischen dem Längswiderstand 106 und dem nicht invertierenden Eingang 14 des Operationsverstärkers 15 ist eine Querkapazität 109 an Masse 110 gelegt.

Diese umschaltbare, d.h. teilweise überbrückbare RC-Kombination reduziert die Anstiegsgeschwindigkeit des Ausgangssignals am gemeinsamen Verbindungspunkt 11 bzw. am Ausgang 1, wenn der weitere steuerbare Schalter 107 in seinen gesperrten Zustand überführt ist. Diese RC-Kombination wird nur während der Umsteuervorgänge aktiviert, in den Zeiträumen zwischen den Umsteuervorgängen ist die RC-Kombination durch Überführen des weiteren steuerbaren Schalters 107 in seinen leitenden Zustand passiv geschaltet. Außerdem unterstützt die RC-Kombination 106, 109 die Wirkung der Integrationsanordnung 18, die mit dem Ausgang 1 verbindbar ist, jedoch in Fig. 5 der Einfachheit halber nicht dargestellt ist. Zur Steuerung der RC-Kombination 106, 109 über den weiteren steuerbaren Schalter 107 kann der Steueranschluß 108 vorteilhaft an die Logikstufe 29 angeschlossen sein. Dabei ist eine Ableitung des weiteren Steuersignals für den Steueranschluß 108 sowohl aus dem Rücksetzsignal vom Rücksetzausgang 41 oder aus dem am Meldeausgang 50 abgegebenen Signal als auch von einem gesondert vorzusehenden Ausgang möglich.

Die Bildung des Rücksetzsignals am Rücksetzausgang 41 der Logikstufe 29 kann bevorzugt derart erfolgen, daß die davon rückgesetzten Stufen der Anordnung nach Fig. 3 nach dem Umladen des Informationssignals aus dem zweiten Zustandssepicherelement 101 in das erste Zustandsspeicherelement 99 vorgenommen wird. Dies kann durch entsprechende Ausbildung der Logikstufe 29 erreicht werden.

Die die Ablaufsteuerstufe bildende Anordnung nach Fig. 5 mit der Logik für den digitalen Umsteuervorgang ist in zwar erweiterter, jedoch prinzipiell unveränderter Fom auch einsetzbar für die Ausgestaltung der Anordnung nach Fig. 5 mit einer größeren Anzahl steuerbarer Schalter, wie dies vorzugsweise bei einem Einsatz in der Audiosignalverarbeitung angezeigt ist. Für diesen Zweck werden z.B. mehr als 50 steuerbare Schalter bei einem Einsatz als Lautstärkesteller gefordert, und zwar generell so viele, wie Dauereinstellstufen für den einzustellenden Parameter (z.B. die Lautstärke eines Audiosignals) gefordert werden. Dabei ergibt sich eine gegenüber der DE 32 00 071 A1 erheblich vereinfachte Schaltungsanordnung durch Verwendung der sogenannten BIMOS-Schalter als steuerbare Schalter, die in großer Anzahl an den gemeinsamen Verbindungspunkt 11 angeschlossen werden können. Erst diese Struktur ermöglicht nämlich auch auf einfache Weise einen wie vorstehend beispielhaft beschriebenen Umsteuervorgang zwischen zwei nicht unmittelbar benachbarten Anzapfungspunkten des ohmschen Spannungsteilers 58 bis 61, also allgemein einen Umsteuervorgang zwischen beliebigen Eingangssignalen.

Gerade für eine Anwendung im Bereich der Audiosignalverarbeitung kann es jedoch wünschenswert sein, eine Umsteuerung von einem Eingangssignal nur zu dem dazu in der vorgegebenen Reihenfolge benachbarten Eingangssignal vorzunehmen, d.h. in der Anordnung nach Fig. 5 nur jeweils zwischen zwei einander benachbarten Anzapfungspunkten des ohmschen Spannungsteilers. Ein Umsteuern von einem Eingangssignal zu einem dazu in der vorgegebenen Reihenfolge nicht benachbarten Eingangssignal, beispielsweise von einem Anzapfungspunkt zu einem dazu nicht benachbarten Anzapfungspunkt, wird dann nacheinander über jedes der in der vorgegebenen Reihenfolge dazwischen liegenden Eingangssignale (über jeden dazwischen liegenden Anzapfungspunkt) vorgenommen. Dazu kann nach jedem Umsteuervorgang dem zweiten Zustandsspeicherelement 101 über seinen Buseingang 102 ein entsprechendes Informationssignal zugeleitet werden, durch das der angestrebte Endzustand stets unmittelbar benachbart zu dem Anfangszustand ist. Über den Buseingang muß so bei einem Umsteuern zwischen zwei beliebigen Eingangssignalen entsprechend den notwendigen einzelnen Umsteuervorgängen eine Folge von Informationssignalen zugeführt werden.

Der für diese Lösung erforderliche Aufwand in der Steuerung der Zufuhr der Informationssignale zum Buseingang 102 kann dadurch auf einfache und wirkungsvolle Art verringert werden, daß die Ablaufsteuerstufe eine Schrittsteuerung umfaßt, durch die das Umsteuern aus dem Anfangszustand in einen beliebigen Endzustand in einzelnen Umsteuervorgängen zwischen je zwei in der vorgegebenen Reihenfolge benachbarten Eingangssignalen durchgeführt wird. Über den Buseingang 102 wird dem zweiten Zustandsspeicherelement 101 somit für jeden gesamten Umsteuervorgang nur noch ein einziges Informationssignal für den letztendlich einzunehmenden Endzustand zugeleitet.

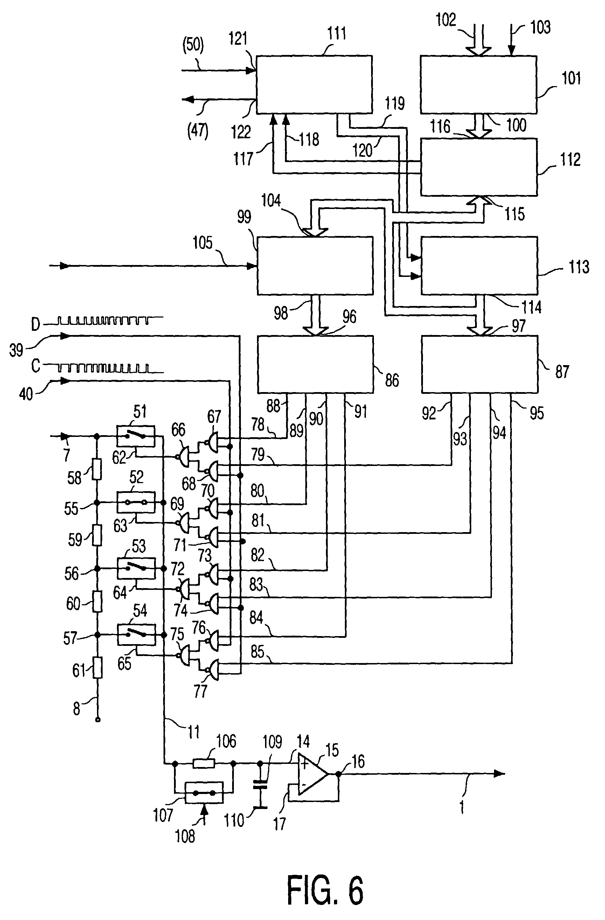

Eine solche Schrittsteuerung ist in der Schaltungsanordnung nach Fig. 6 beispielhaft dargestellt, die aus einer Erweiterung des Ausführungsbeispiels nach Fig. 5 hervorgegangen ist. Im Gegensatz zu der Anordnung gemäß DE 32 00 071 A1 ist ein solches Umsteuern aber grundsätzlich nicht erforderlich, sondern nur wahlweise anzuwenden und insbesondere für die Vereinfachung von Steuerprogrammen in der Audiosignalverarbeitung beispielsweise für weiches Stummschalten und Lautstärkeeeinstellung mit einem Drehknopf sehr vorteilhaft.

Das Ausführungsbeispiel nach Fig. 6 enthält dafür eine Schrittsteuerung 111, einen Komparator 112 und einen Aufwärts-Abwärts-Zähler 113. Der Komparator 112 und der Aufwärts-Abwärts-Zähler 113 ergänzen das zweite Zusrandsspeicherelement 101 und wandeln seine Bedeutung gegenüber dem Ausführungsbeispiel nach Fig. 5 in der Weise, daß für jeden einzelnen Umsteuervorgang das Informationssignal für das in der vorgegebenen Reihenfolge benachbarte Eingangssignal - das nachfolgende Eingangssignal -jetzt im Aufwärts-Abwärts-Zähler 113 gespeichert ist, wohingegen das zweite Zustandsspeicherelement 101 in seiner zu Fig. 5 beschriebenen Ausgestaltung während des gesamten Umsteuervorgangs, d.h. während aller einzelnen Umsteuervorgänge unverändert, das Informationssignal für den am Ende des gesamten Umsteuervorgangs zu erreichenden Endzustand gespeichert enthält. Entsprechend wird nach jedem einzelnen Umsteuervorgang das Informationssignal für den jeweils erreichten Zustand aus dem Aufwärts-Abwärts-Zähler 113 als Informationssignal für das voraufgehende Eingangssignal in das erste Zustandsspeicherelement 99 übertragen und im Aufwärts-Abwärts-Zähler 113 daraufhin durch einen Zählschritt ein Informationssignal für ein neues nachfolgendes Eingangssignal erzeugt. Dieser Vorgang und die dafür eingesetzte Schaltungsanordnung werden nachfolgend näher beschrieben.

In Fig. 6 weist der Aufwärts-Abwärts-Zähler 113 einen Ausgang 114 auf, an dem die aktuelle Zählerstellung des Aufwärts-Abwärts-Zählers 114 abgegeben wird, die ein Informationssignal für das nachfolgende Eingangssignal bildet. Dieses wird über eine Leitungsverbindung dem Eingang 114 des ersten Zustandsspeicherelements 99 zur Übernahme nach dem einzelnen Umsteuervorgang sowie einem ersten Eingang 115 des Komparators 112 zugeführt. Ein zweiter Eingang 116 des Komparators 112 ist mit dem Ausgang 100 des zweiten Zustandsspeicherelements 101 verbunden. Dem zweiten Eingang 116 des Komparators 112 wird somit während des gesamten Umsteuervorgangs unverändert das Informationssignal für den Endzustand des gesamten Umsteuervorgangs zugeführt. Im Komparator 112 werden die Signale von den Eingängen 115, 116 miteinander verglichen. Das Ergebnis dieses Vergleichs wird über eine erste Ergebnisleitung 117 und eine zweite Ergebnisleitung 118 an die Schrittsteuerung 111 übertragen. Dabei führt die erste Ergebnisleitung 117 ein Signal mit einer Information darüber, ob die Informationssignale an den Eingängen 115, 116 des Komparators 112 gleich oder ungleich sind (Gleichheitssignal). Das Signal auf der zweiten Ergebnisleitung enthält eine Information über das Vorzeichen der Differenz der beiden Informationssignale an den Eingängen 115, 116 (Vorzeichensignal). Somit liefert das Gleichheitssignal der Schrittsteuerung 111 eine Information darüber, ob bereits der Endzustand erreicht wurde, während das Vorzeichensignal eine Information über die Richtung des nächsten vorzunehmenden einzelnen Umsteuervorgangs liefert. Daraus werden in der Schrittsteuerung 111 ein Aufwärtszählsignal und ein Abwärtszählsignal erzeugt und über eine Aufwärtszählleitung 119 bzw. eine Abwärtszählleitung 120 dem Aufwärts-Abwärts-Zähler 113 an seinen Aufwärtszähleingang bzw. Abwärtszähleingang zugeführt. Dies erfolgt in der Weise, daß durch jeden Zählschritt des Aufwärts-Abwärts-Zählers 113 zwischen je zwei einzelnen Umsteuervorgängen die aktuelle Zählerstellung dem Informationssignal über den Endzustand um einen Zählschritt weiter angenähert wird. Auf diese Weise wechseln die einzelnen Umsteuervorgänge zwischen dem jeweils voraufgehenden Eingangssignal und dem jeweils nachfolgenden Eingangssignal, das laden des vom Aufwärts-Abwärts-Zähler 113 abgenommenen Informationssignal über dieses jeweils nachfolgende Eingangssignal in das erste Zustandsspeicherelement 99, der Vergleich der genannten, aktuellen Zählerstellung des Aufwärts-Abwärts-Zählers 113 mit dem Informationssignal aus dem zweiten Zusrandsspeicherelement 101 im Komparator 112 und der daraus mittels der Schrittsteuerung 111 abgeleitete nächste Zählschritt einander zyklisch ab, bis das Informationssignal im ersten Zustandsspeicherelement 99 den Wert desjenigen im zweiten Zustandsspeicherelement 101 angenommen hat. Auch die aktuelle Zählerstellung des Aufwärts-Abwärts-Zählers 113 stimmt dann mit diesem Informationssignal überein, worauf- durch den Komparator 12 gesteuert - die Schrittsteuerung 111 den gesamten Umsteuervorgang beendet.

Zur Bewerkstelligung des beschriebenen Funktionsablaufs werden in der Schrittsteuerung 111 die Signale vom Meldeausgang 50 der Logikstufe 29, mit denen der Abschluß eines Umsteuervorgangs gemeldet wird, ausgewertet, sowie ein Startsignal für das Auslösen eines weiteren Umsteuervorgangs erzeugt und der Logikstufe 29 zugeführt. Dazu ist ein Meldeeingang 121 der Schrittsteuerung 111 mit dem Meldeausgang 50 der Logikstufe 29 verbunden, und an einem Startausgang 122, der mit dem Starteingang 47 der Logikstufe 29 verbunden ist, wird von der Schrittsteuerung 111 das Startsignal abgegeben. Auch diese Funktionen müssen im übrigen bei einem Einsatz des Ausführungsbeispiels nach Fig. 5 von der Bussteuerung übernommen werden, über die der Buseingang 102 und der Ladesignaleingang 103 mir entsprechenden Signalen gespeist werden.

In einem bevorzugten Dimensionierungsbeispiel wird die RC-Kombination 106, 109 derart dimensioniert, daß durch sie die Anstiegsgeschwindigkeit des Operationsverstärkers 15 gegenüber einem Betrieb ohne Beschaltung durch die RC-Kombination um einen Faktor 2 bis 3 verringert wird. Dies verhindert zuverlässig eventuelle dynamische Übersteuerungen des Operationsverstärkers 15 und verhindert so eine nichtlineare Verzerrung des Umsteuervorgangs. Insbesondere sollte der Längswiderstand 106 merklich größer als der Innenwiderstand des ohmschen Spannungsteilers 58 bis 61 dimensioniert sein, wodurch die dynamische Belastung dieses ohmschen Spannungsteilers verringert wird.

Beim Einsatz der erfindungsgemäßen Schaltungsanordnung in der Audiosignalverarbeitung zeigt sich eine hörbare Verbesserung der Audiosignalqualität besonders bei schnellem Stummschalten eines Audiosignals großer Amplitude.

In einer Weiterentwicklung der Ausführungsbeispiele nach den Fig. 5 und 6 ist auch eine Kombinationsform möglich, bei der umschaltbar ein Umsteuervorgang zwischen zwei beliebigen Eingangssignalen einerseits und zwischen benachbarten Eingangssignalen andererseits vorgenommen werden kann. Die Auswahl zwischen diesen beiden Funktionsabläufen kann beispielsweise von der Amplitude des zu verarbeitenden Eingangssignals abhängig gemacht werden. So können beispielsweise im Bereich geringerer Amplitude die Unterschiede zwischen den Amplituden der Eingangssignale, zwischen denen umgesteuert werden soll, größer gewählt werden als im Bereich höherer Amplitude der Eingangssignale.

## Patentansprüche

1. Schaltungsanordnung zum Erzeugen eines Ausgangssignals an einem Ausgang durch Verknüpfung wenigstens eines ersten und eines zweiten Eingangssignals, mit je wenigstens einem steuerbaren Schalter zum Zuführen je eines der Eingangssignale zum Ausgang, wobei zum Umsteuern des Ausgangs von einem der Eingangssignale zum anderen ein erster der steuerbaren Schalter allmählich vom gesperrten hin zum leitenden Zustand und ein zweiter der steuerbaren Schalter komplementär dazu vom leitenden hin zum gesperrten Zustand umgesteuert wird, dadurch gekennzeichnet,
daß die steuerbaren Schalter mit komplementär zueinander allmählich verändertem Tastverhältnis zwischen ihrem vollständig leitenden und ihrem vollständig gesperrten Zustand einander entgegengesetzt hin- und hergeschaltet werden.

2. Schaltungsanordnung nach Anspruch 1, gekennzeichnet durch
eine mit dem Ausgang verbundene Integrationsanordnung zum Integrieren bzw. Tiefpaßfiltern des Ausgangssignals.

3. Schaltungsanordnung nach Anspruch 1, dadurch gekennzeichnet,
daß das Umsteuern des Ausgangs von einem der Eingangssignale zum anderen innerhalb eines Umsteuerzeitintervalls vorgebbarer Dauer vorgenommen wird.

4. Schaltungsanordnung nach Anspruch 1, gekennzeichnet durch
eine Steueranordnung zum Erzeugen zweier zueinander komplementärer Steuersignale zum einander komplementären Hin- und Herschalten der steuerbaren Schalter.

5. Schaltungsanordnung nach Anspruch 4, dadurch gekennzeichnet,
daß die Steuersignale durch in ihrer Pulsdichte bzw. Pulsfrequenz gesteuerte Impulssignale gebildet sind.

6. Schaltungsanordnung nach Anspruch 5, dadurch gekennzeichnet,
daß die Steueranordnung zum schrittweisen Ändern der Pulsdichte bzw. Pulsfrequenz der Steuersignale ausgebildet ist.

7. Schaltungsanordnung nach Anspruch 6, dadurch gekennzeichnet,
daß sowohl für die Pulsdichte bzw. Pulsfrequenz der Steuersignale als auch für die Wiederholungsfrequenz der Schritte des schrittweisen Änderns der Pulsdichte bzw. Pulsfrequenz der Steuersignale ausschließlich Frequenzen außerhalb des hörbaren Frequenzbereichs verwendet werden.

8. Schaltungsanordnung nach Anspruch 4, 5, 6 oder 7, dadurch gekennzeichnet,
daß die Steueranordnung eine Akkumulationsschaltung umfaßt, der Ausgangsdatensignale einer Zählerstufe zum Aufakkumulieren zugeführt werden und von der ein Übertragssignal zum Steuern einer bistabilen D-Kippstufe abgeleitet wird, wobei Zählerstufe, Akkumulationsschaltung und bistabile D-Kippstufe aus einem gemeinsamen Taktsignal getaktet werden und den Ausgängen der bistabilen D-Kippstufe die komplementären Steuersignale entnehmbar sind.

9. Schaltungsanordnung nach Anspruch 8, dadurch gekennzeichnet,
daß der Zählerstufe das Taktsignal über eine einstellbare Taktfrequenzteilerstufe zugeführt wird.

10. Schaltungsanordnung nach einem der vorhergehenden Ansprüche, gekennzeichnet durch
wenigstens drei steuerbare Schalter zum Zuführen je eines Eingangssignals, wobei das Umsteuern des Ausgangs von jedem der Eingangssignale zu einem beliebig wählbaren der anderen Eingangssignale durchführbar ist.

11. Schaltungsanordnung nach einem der Ansprüche 1 bis 9, gekennzeichnet durch
wenigstens drei steuerbare Schalter zum Zuführen je eines Eingangssignals, wobei diese Eingangssignale gemäß ihren Signalpegeln in eine vorgegebene Reihenfolge eingeordnet sind und das Umsteuern des Ausgangs von je einem der Eingangssignale nur zu den in dieser Reihenfolge benachbarten Eingangssignalen vorgenommen wird.

12. Schaltungsanordnung nach Anspruch 10 oder 11, dadurch gekennzeichnet,
daß die Steueranordnung eine Ablaufsteuerstufe umfaßt, der ausgehend von einem Anfangszustand der Schaltungsanordnung, in dem ein erstes ausgewähltes Eingangssignal dem Ausgang zugeführt wird, über eine Datenübertragungsstrecke ein Informationssignal über ein zweites ausgewähltes Eingangssignal zugeleitet wird, welches in einem Endzustand der Schaltungsanordnung nach dem Umsteuern des Ausgangs diesem zugeführt wird.

13. Schaltungsanordnung nach Anspruch 12, dadurch gekennzeichnet,
daß die Ablaufsteuerstufe ein erstes Zustandsspeicherelement zum Speichern eines Informationssignals für den Anfangszustand und ein zweites Zustandsspeicherelement zum Speichern des Informationssignals für den Endzustand umfaßt.

14. Schaltungsanordnung nach Anspruch 13, dadurch gekennzeichnet,
daß durch die Informationssignale die im Anfangs- bzw. Endzustand dem Ausgang zuzuführenden Eingangssignale ausgewählt werden und das Umsteuern zwischen diesen Eingangssignalen vorgenommen wird, und daß nach Ausführen des Umsteuerns das Informationssignal für den Endzustand vom ersten Zustandsspeicherelement in das zweite Zustandsspeicherelement übertragen wird, worauf das erste Zustandsspeicherelement zum Zuleiten eines neuen Informationssignals für einen neuen (weiteren) Endzustand bereit ist.

15. Schaltungsanordnung nach Anspruch 12, 13 oder 14, bei der jeweils das Umsteuern von einem Eingangssignal nur zu dem dazu in der vorgegebenen Reihenfolge benachbarten Eingangssignal vorgenommen wird und ein Umsteuern von einem Eingangssignal zu einem dazu nicht benachbarten Eingangssignal nacheinander über jedes der in der vorgegebenen Reihenfolge dazwischen liegenden Eingangssignale erfolgt, dadurch gekennzeichnet,
daß die Ablaufsteuerstufe eine Schrittsteuerung umfaßt, durch die das Umsteuern aus dem Anfangszusrand in den Endzustand in einzelnen Umsteuervorgängen zwischen je zwei in der vorgegebenen Reihenfolge benachbarten Eingangssignalen durchgeführt wird.

16. Schaltungsanordnung nach Anspruch 15 in Verbindung mit Anspruch 13, dadurch gekennzeichnet,
daß bei jedem der einzelnen Umsteuervorgänge im ersten Zustandsspeicherelement das Informationssignal für das zu Beginn dieses einzelnen Umsteuervorgangs dem Ausgang zuzuführende Eingangssignal (im folgenden: 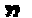 voraufgehendes Eingangssignal") gespeichert ist und daß im zweiten Zustandsspeicherelement das Informationssignal für das in der vorgegebenen Reihenfolge benachbarte Eingangssignal (im folgenden: 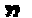 nachfolgendes Eingangssignal") gespeichert ist.

17. Schaltungsanordnung nach Anspruch 16 in Verbindung mit Anspruch 14, dadurch gekennzeichnet,
daß bei jedem der einzelnen Umsteuervorgänge durch die Informationssignale das voraufgehende Eingangssignal bzw. das nachfolgende Eingangssignal ausgewählt wird und der einzelne Umsteuervorgang zwischen diesen Eingangssignalen vorgenommen wird, und daß nach Ausführen dieses einzelnen Umsteuervorgangs das Informationssignal für das nachfolgende Eingangssignal vom ersten Zustandsspeicherelement in das zweite Zustandsspeicherelement übertragen wird, worauf das erste Zusrandsspeicherelement zum Zuleiten des Informationssignals für das nächste in der vorgegebenen Reihenfolge benachbarte Eingangssignal bereit ist, bis das Informationssignal für den Endzustand in das zweite Zustandsspeicherelement übertragen ist.

18. Schaltungsanordnung nach einem der vorhergehenden Ansprüche, dadurch gekennzeichnet,
daß die Eingangssignale durch Pegelabstufung aus einem gemeinsamen Eingangssignal abgeleitet sind.

19. Gerät zur Signalverarbeitung, gekennzeichnet durch
eine Schaltungsanordnung nach einem der Ansprüche 1 bis 18

20. Gerät zur Audiosignalverarbeitung, gekennzeichnet durch
eine Schaltungsanordnung nach einem der Ansprüche 1 bis 18.
